(19) **Europäisches Patentamt / European Patent Office / Office européen des brevets**

(11) **EP 4 579 378 A1**

(12) **EUROPEAN PATENT APPLICATION**
published in accordance with Art. 153(4) EPC

(43) Date of publication:
02.07.2025 Bulletin 2025/27

(21) Application number: 23857343.0

(22) Date of filing: 22.08.2023

(51) International Patent Classification (IPC):
$G06E\ 1/00^{(2006.01)}$   $H03K\ 19/23^{(2006.01)}$
$G06N\ 10/00^{(2022.01)}$   $H01L\ 29/66^{(2006.01)}$
$H01L\ 29/82^{(2006.01)}$   $H10N\ 50/10^{(2023.01)}$

(52) Cooperative Patent Classification (CPC):
G06E 1/00; G06N 10/00; H03K 19/23; H10D 48/30;
H10D 48/40; H10N 50/10

(86) International application number:
PCT/JP2023/030163

(87) International publication number:
WO 2024/043234 (29.02.2024 Gazette 2024/09)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 25.08.2022 JP 2022133853

(71) Applicant: Japan Science and Technology
Agency
Kawaguchi-shi, Saitama 332-0012 (JP)

(72) Inventors:
• KOHDA Makoto
Sendai-shi Miyagi 980-8577 (JP)
• KARUBE Shutaro
Sendai-shi Miyagi 980-8577 (JP)

• ZHANG Chaoliang
Sendai-shi Miyagi 980-8577 (JP)
• KIKUCHI Keito
Sendai-shi Miyagi 980-8577 (JP)
• NAKAJIMA Kai
Sendai-shi Miyagi 980-8577 (JP)
• FURUDATE Kaisei
Sendai-shi Miyagi 980-8577 (JP)
• HIYAMA Miari
Sendai-shi Miyagi 980-8577 (JP)
• ISHIHARA Jun
Sendai-shi Miyagi 980-8577 (JP)

(74) Representative: Noble, Nicholas et al
Kilburn & Strode LLP
Lacon London
84 Theobalds Road
London WC1X 8NL (GB)

(54) **MAJORITY-DECISION LOGIC DEVICE, PHOTOELECTRIC CONVERSION DEVICE, OPTICAL COMMUNICATION LOGIC DEVICE, AND METHOD FOR CONTROLLING MAJORITY-DECISION LOGIC DEVICE**

(57) A majority logic device 1 comprises a nonmagnetic semiconductor layer 10 comprising a material which, upon irradiation of light having at least two mutually different polarization states, generates electron spin waves having different phases depending on the polarization states. The nonmagnetic semiconductor layer 10 comprises three or more input sections for inputting optical signals and at least one output section for outputting the result of interference of the electron spin waves. The length of the projection of the distance between adjacent input sections as projected in the oscillating direction of the electron spin waves is an integer multiple of the wavelength of the electron spin waves.

EP 4 579 378 A1

# FIG. 1

## Description

TECHNICAL FIELD

This invention relates to a majority logic device, a photoelectric conversion device, an optical communication logic device and a method for controlling a majority logic device.

BACKGROUND ART

Majority logic devices using spin waves, i.e., magnons, produced by continuous changes in the magnetic order of ferromagnetic materials are disclosed, e.g., Non Patent Literature 1. Majority logic devices using spin waves, i.e., electron spin waves, produced by sustained spin precession of free electrons due to an effective magnetic field are also known. For example, a majority logic device using spin polarization information of Persistent Spin Helix, i.e., PSH, generated in a two-dimensional electron gas is disclosed, e.g., Patent Literature 1.

RELATED-ART LITERATURE

PATENT LITERATURE

Patent Literature 1: Japanese Patent Publication. 2015-518267

NON PATENT LITERATURE

Non Patent Literature 1: "Reconfigurable submicrometer spin-wave majority gate with electrical transducers" Talmelli et al. Science Advances, vol. 6, issue 51, p. eabb4042, 18 December 2020

Non Patent Literature 2: "Gate-controlled switching between persistent and inverse persistent spin helix states", Yoshizumi, A. Sasaki, M. Kohda and J. Nitta", APPLIED PHYSICS LETTERS 108, 132402 (2016)

Non Patent Document 3: "Direct mapping of the formation of a persistent spin helix", M. P. Walser, C. Reichl, W. Wegscheider and G. Salis, Nature Phys. advance online publication, 12 August 2012

SUMMARY OF INVENTION

TECHNICAL PROBLEM

The technique described in Non Patent Literature 1 requires that the input and output sections of a majority logic device be arranged in series along a linear ferromagnetic waveguide. In this case, the structure of majority logic circuits is limited to a one-dimensional one, which limits the degree of freedom of arrangement. Therefore, the degree of freedom of circuit configuration is low, and it is not possible to realize a variety of circuits, such as two-dimensional structures, for example. Furthermore, this technology uses the magnetic field generated by highfrequency electrical signals to generate magnons. This requires the use of an electrical pulsed magnetic field as input, making it difficult to achieve sophisticated integration with optical signals used in optical communications and other applications.

The technique described in Patent Literature 1 uses electron spin waves, PSH, instead of magnons, but again, the logic input section is arranged in one dimension. Furthermore, to prevent mixing of electron spin waves in the logic input sections, it is necessary to provide a predetermined gap between each of the logic input sections. Therefore, this technique also has the problem of low flexibility in circuit configuration.

The present disclosure was made in view of these problems, and its purpose is to realize a majority logic device with a high degree of freedom in circuit configuration and good consistency with optical signals.

SOLUTION TO PROBLEM

In order to solve the above problem, a majority logic device according to a certain aspect of the invention comprises a nonmagnetic semiconductor layer comprising a material which, upon irradiation of light having at least two mutually different polarization states, generates electron spin waves having different phases depending on the polarization states. The nonmagnetic semiconductor layer comprises three or more input sections for inputting optical signals and at least one output section for outputting the result of interference of the electron spin waves. The deviation of the length of the projection of the distance between adjacent input sections in the oscillating direction of the electron spin wave from an integer multiple of the wavelength of the electron spin wave is within 25% of the wavelength.

In one embodiment, the length of the projection of the distance between adjacent input sections in the oscillating direction of the electron spin wave may be an integer multiple of the wavelength of the electron spin wave.

In one embodiment, majority logic device may further comprise a waveguide layer stacked directly or through another layer on the nonmagnetic semiconductor layer. The waveguide layer comprises waveguides individually connected to each of the three or more input sections directly or via other layers. The majority logic device has a mirror section for guiding light through the waveguide to the respective input section at the location where the waveguide is connected to each of the three or more input sections directly or individually through other layers.

In one embodiment, the waveguides may be arranged in a direction that is substantially orthogonal to the oscillating direction of the electron spin wave.

In one embodiment, the output section may be located at an equal distance from each of the three or more input sections.

In one embodiment, the electron spin wave may be an inverse Persistent Spin Helix generated in a two-dimensional electron gas. The three or more input sections are arranged in directions in plane of the nonmagnetic semiconductor layer.

In one embodiment, the deviation between the absolute value of $\alpha$ and the absolute value of $\beta$ may be within 15% of the average of the absolute values where the Rashba spin-orbit interaction coefficient is $\alpha$ and the Dresselhaus spin-orbit interaction coefficient is $\beta$.

In one embodiment, the three or more input sections may be located at each vertex of a polygon.

In one embodiment, the three or more input sections may be located at each vertex of an equilateral triangle. The output section is located at the center of gravity of the equilateral triangle.

In one embodiment, the electron spin wave may be an electron spin wave transformed into a helical spin mode by confinement of a two-dimensional electron gas into a one-dimensional fine wire structure. The three or more input sections are arranged in a one-dimensional direction on the nonmagnetic semiconductor layer.

Another aspect of the invention is a photoelectric conversion device. This photoelectric conversion device comprises the above mentioned majority logic device and a magnetoresistive device for converting the spin polarization of the output section into an electrical signal.

Yet another aspect of the invention is an optical communication logic device. This optical communication logic device comprises the above mentioned majority logic device and an optical output element.

Yet another aspect of the invention is also an optical communication logic device. This optical communication logic device comprises the above mentioned majority logic device and a wavelength multiplexed optical input element.

Another aspect of the invention is a method of controlling a majority logic device. The majority logic device comprises a nonmagnetic semiconductor layer comprising a material which, upon irradiation of light having at least two mutually different polarization states, generates electron spin waves having different phases depending on the polarization states. The nonmagnetic semiconductor layer comprises three or more input sections for inputting optical signals and at least one output section for outputting the result of interference of the electron spin waves. The deviation of the length of the projection of the distance between adjacent input sections in the oscillating direction of the electron spin wave from an integer multiple of the wavelength of the electron spin wave is within 25% of the wavelength. The optical signals are optical signals modulated with right-handed circularly polarized light and left-handed circularly polarized light.

In one embodiment, the three or more input sections may comprise a first input section and a second input section. When the distance between the first input section and the output section is longer than the distance between the second input section and the output section, the intensity of the optical signal input to the first input section is compensated to be greater than the intensity of the optical signal input to the second input section.

In one embodiment, at least one of the three or more input sections may be input with an optical signal that is always either right-handed or left-handed circularly polarized.

Another aspect of the invention is a majority logic device. This majority logic device comprises a two-dimensional wire structure in which three or more odd one-dimensional fine wire structures for signal input meet at a single junction point. Each of the one-dimensional fine wire structures for signal input has a nonmagnetic semiconductor layer comprising a material which, upon irradiation of light having at least two mutually different polarization states, generates electron spin waves having different phases depending on the polarization states. Each of the one-dimensional fine wire structures for signal input has an input section for inputting optical signals before the junction point. The junction point comprises an output section which outputs the result of interference of the electron spin waves at the junction point. The deviation of the length of the projection of the distance between the junction point and the respective input sections of the one-dimensional fine wire structure for signal input in the oscillating direction of the electron spin wave from an integer multiple of the wavelength of the electron spin wave is within 25% of the wavelength.

In one embodiment, the electron spin wave may be an inverse Persistent Spin Helix generated in a two-dimensional electron gas.

In one embodiment, the deviation between the absolute value of $\alpha$ and the absolute value of $\beta$ may be within 15% of the average of the absolute values, where the Rashba spin-orbit interaction coefficient is $\alpha$ and the Dresselhaus spin-orbit interaction coefficient is $\beta$.

In one embodiment, the majority logic device may further comprise a one-dimensional confluent fine wire structure extending from the junction point. In this case, instead of a junction point, the one-dimensional confluent fine wire structure may comprise an output section.

In one embodiment, the majority logic device may comprise a plurality of individual majority logic devices each comprising the above mentioned majority logic device. One-dimensional confluent fine wire structures of the plurality of individual majority logic devices meet at a single final junction point. An output section may be provided which outputs the results of interference of electron spin waves at the final junction point.

Another aspect of the invention is a majority logic device. This majority logic device comprises a two-dimensional wire structure in which three or more odd one-dimensional fine wire structures for signal input meet at a single junction point. Each of the one-dimensional fine wire structures for signal input has a nonmagnetic semiconductor layer comprising a material which, upon irradiation of light having at least two mutually different polarization states, generates electron spin waves having different phases depending on the polarization states. Each of the one-dimensional fine wire structures for signal input has an input section for inputting optical signals before the junction point. The junction point comprises an output section which outputs the result of interference of the electron spin waves at the junction point. The deviation of the distance between the junction point and the respective input sections of the one-dimensional fine wire structure for signal input from an integer multiple of the wavelength of the electron spin wave is within 25% of the wavelength.

In one embodiment, only the Rashba spin-orbit interaction may be active as the spin-orbit interaction with respect to the electron spin wave.

In one embodiment, the majority logic device may further comprise a one-dimensional confluent fine wire structure extending from the junction point Instead of the junction point, the one-dimensional confluent fine wire structure comprises an output section.

In one embodiment, the majority logic device may comprise a plurality of cellular majority logic devices each comprising the above mentioned majority logic device. One-dimensional confluent fine wire structures of the plurality of cellular majority logic devices meet at a single final junction point. An output section is provided which outputs the results of interference of the electron spin waves at the final junction point.

Any combination of the above components, and any conversion of the expressions of the present disclosure between methods, devices, systems, recording media, computer programs, etc., is also valid as an aspect of the present disclosure.

ADVANTAGEOUS EFFECTS OF INVENTION

According to the present disclosure, the purpose of the present invention is to realize a majority logic device with a high degree of freedom in circuit configuration and good consistency with optical signals.

BRIEF DESCRIPTION OF DRAWINGS

[FIG. 1] Fig. 1 shows a schematic diagram of a majority logic device according to the first embodiment.
[FIG. 2] Fig. 2 shows a schematic diagram showing how the result of the interference of three electron spin waves is read out at the output section and then the result is output.
[FIG. 3] Fig. 3 shows a schematic diagram showing the polarization state of light irradiated to the input section and the phase state of the electron spin wave after interference.
[FIG. 4] Fig. 4 shows a schematic diagram showing the polarization state of light irradiated to the input section and the phase state of the electron spin wave after interference.
[FIG. 5] Fig. 5 shows a schematic diagram showing the polarization state of light irradiated in the input section and the phase state of the electron spin wave after interference.
[FIG. 6] Fig. 6 shows a schematic diagram showing the polarization state of light irradiated to the input section and the phase state of the electron spin wave after interference.
[FIG. 7] Fig. 7 shows a schematic diagram of a nonmagnetic semiconductor layer in which the input section is arranged in a regular hexagonal shape and the output section is placed at the center of gravity of this regular hexagon.
[FIG. 8] Fig. 8 shows a schematic diagram of a nonmagnetic semiconductor layer in which the input section and output section are arranged in a one-dimensional direction.
[FIG. 9] Fig. 9 shows a schematic diagram showing the generation of wavelength multiplexed optical signals to be input to the wavelength multiplexed optical input element according to the fourth embodiment.
[FIG. 10] Fig. 10 shows a schematic diagram of the wavelength multiplexed optical input element used in the fourth embodiment.
[FIG. 11] Fig. 11 shows a schematic diagram of a majority logic device used in the second embodiment.
[FIG. 12] Fig. 12 shows a schematic diagram of a majority logic device when one of the input sections is shifted in the x direction.
[FIG. 13] Fig. 13 shows the simulation results of the time evolution of the phase of the electron spin wave at $(x, y) = (0, 0)$ when one of the input sections is shifted in the x direction.
[FIG. 14] Fig. 14 shows the polarization state of the light and the phase of the electron spin wave after interference when $\Delta x = 0$.
[FIG. 15] Fig. 15 shows the polarization state of the light and the phase of the electron spin wave after interference when $\Delta x = 0.2\lambda$.
[FIG. 16] Fig. 16 shows the polarization state of the light and the phase of the electron spin wave after interference when $\Delta x = 0.4\lambda$.
[FIG. 17] Fig. 17 shows the simulation results of the phase of the electron spin wave at $(x, y) = (0, 0)$ when one of the input sections is shifted in the x direction and the y direction.
[FIG. 18] Fig. 18 shows a schematic diagram of a nonmagnetic semiconductor layer in which the input section is arranged in a regular pentagonal shape and the output section is placed at the center of gravity of this regular pentagon.

[FIG. 19] Fig. 19 shows a schematic diagram of a majority logic device according to the sixth embodiment.

[FIG. 20] Fig. 20 shows a schematic diagram of a majority logic device according to the seventh embodiment.

[FIG. 21] Fig. 21 shows a schematic diagram of a majority logic device according to the eighth embodiment.

[FIG. 22] Fig. 22 shows a circuit diagram of a conventional majority logic device.

[FIG. 23] Fig. 23 shows a schematic diagram of a majority logic device according to the ninth embodiment.

[FIG. 24] Fig. 24 shows a schematic diagram of a majority logic device according to the tenth embodiment.

DESCRIPTION OF EMBODIMENTS

The invention will be explained below with reference to the drawings based on suitable embodiments. The embodiments are examples rather than limitations of the invention. Not all features or combinations of features described in the embodiments are necessarily essential to the invention. Identical or equivalent components, parts, and processes shown in each drawing shall be given the same symbol, and duplicate explanations will be omitted where appropriate. The scale and shape of each part shown in each drawing are set for convenience in order to facilitate explanation, and should not be construed as limiting unless otherwise noted. When terms such as "first," "second," etc. are used in this specification or in the claims, unless otherwise mentioned, such terms do not indicate any order or degree of importance, but only to distinguish one configuration from another. In addition, in each drawing, some parts of the components that are not important to the description of the embodiment are omitted from the drawing.

The first embodiment

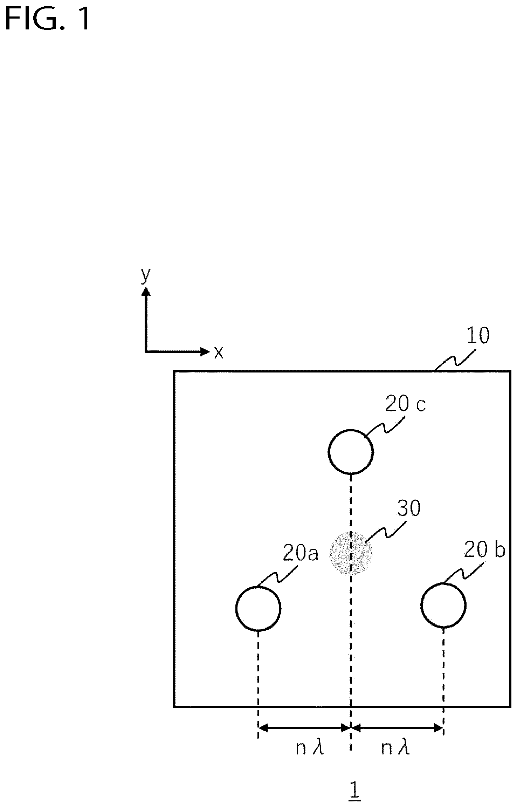

Figure 1 schematically shows a Majority logic device 1 according to the first embodiment. The majority logic device 1 is comprises a nonmagnetic semiconductor layer 10. The nonmagnetic semiconductor layer 10 comprises input sections 20a, 20b, and 20c, and an output section 30. In Figure 1, the x-axis is right-handed facing toward the paper surface and the y-axis is upward facing, and the same applies hereinafter unless otherwise noted. Here, the x-axis is the oscillating direction of the electron spin wave described below, and is determined by the crystallographic orientation of the nonmagnetic semiconductor layer 10.

In the example of Figure 1, the input sections 20a, 20b, and 20c are located at each vertex of an equilateral triangle, and the output section 30 is located at the center of gravity of this equilateral triangle.

In other words, the output section 30 is located at an equal distance from each of the input sections 20a, 20b, and 20c.

The nonmagnetic semiconductor layer 10 comprises a material which, upon irradiation of light having at least two mutually different polarization states, generates electron spin waves having different phases depending on the polarization states. Optical signals are input to the input sections 20a, 20b and 20c, respectively. The output section 30 reads and outputs the result of the interference of the electron spin waves generated by this optical signal.

Hereafter, the wavelength of the electron spin wave is denoted as $\lambda$ and n is an integer. As shown in Figure 1, $n\lambda$ is the length of the projection of the distance between the input section 20a and the input section 20c in the oscillating direction of the electron spin wave, i.e., x-axis direction. Similarly, the length of the projection of the distance between the input section 20b and the input section 20c in the oscillating direction of the electron spin wave is $n\lambda$. Furthermore, the length of the projection of the distance between the input section 20a and the input section 20b in the oscillating direction of the electron spin wave is $2n\lambda$. Thus, in the nonmagnetic semiconductor layer 10, the length of the projection of the distance between adjacent input sections in the oscillating direction of the electron spin wave is an integer multiple of the wavelength of the electron spin wave.

The nonmagnetic semiconductor layer 10 will now be described in more detail. In the following example, it is assumed that there are two types of polarization states of the light to be irradiated, i.e., right-handed circular polarization and left-handed circular polarization. When such light is irradiated to the input sections 20a, 20b and 20c, the nonmagnetic semiconductor layer 10 generates electron spin waves with phase 0 for right-handed circularly polarized light and with phase $\pi$ for left-handed circularly polarized light, respectively. Hereafter, the electron spin wave of phase 0 will be associated with the logical value "0" ,i.e., "false", and the electron spin wave of phase $\pi$ with the logical value "1" ,i.e., "true", respectively. Thus, in this case, the right-handed circular polarization of the irradiated light corresponds to the logical value 0, and the left-handed circular polarization of the irradiated light corresponds to the logical value 1.

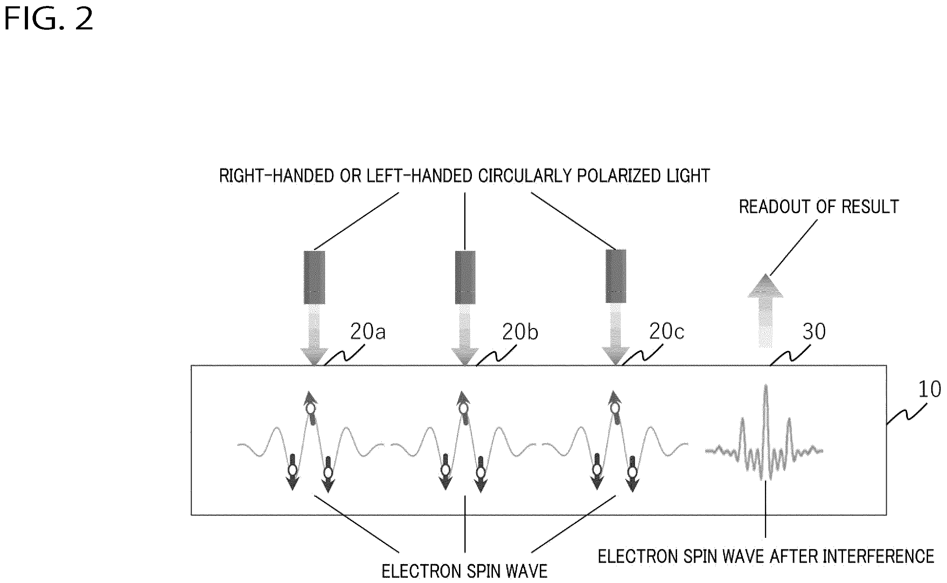

The electron spin waves generated by the light irradiated to the input sections 20a, 20b and 20c interfere with each other. In this case, electron spin waves with a phase of both 0 strengthen each other and electron spin waves with a phase of both $\pi$ strengthen each other, due to interference. On the contrary, electron spin waves with one phase of 0 and the other phase of $\pi$ weaken each other due to interference. The result of the interference of the three electron spin waves is read out at the output section and then the result is output. Figure 2 shows schematically how this happens.

Hereafter, the logical values corresponding to the polarization state of the light irradiated to the input sections 20a, 20b and 20c are expressed as vectors (20a, 20b, 20c). For example, (20a, 20b, 20c) = (0, 1, 0) means that the light irradiated to input section 20a is right-handed circularly polarized, i.e., phase 0 of electron spin wave, logical value 0, the light irradiated to input section 20b is left-handed circularly polarized i.e., phase $\pi$ of electron spin wave, logical value 1, and that the light irradiated to input section 20c is right-handed circularly polarized i.e., phase 0 of electron spin wave, logical value 0.

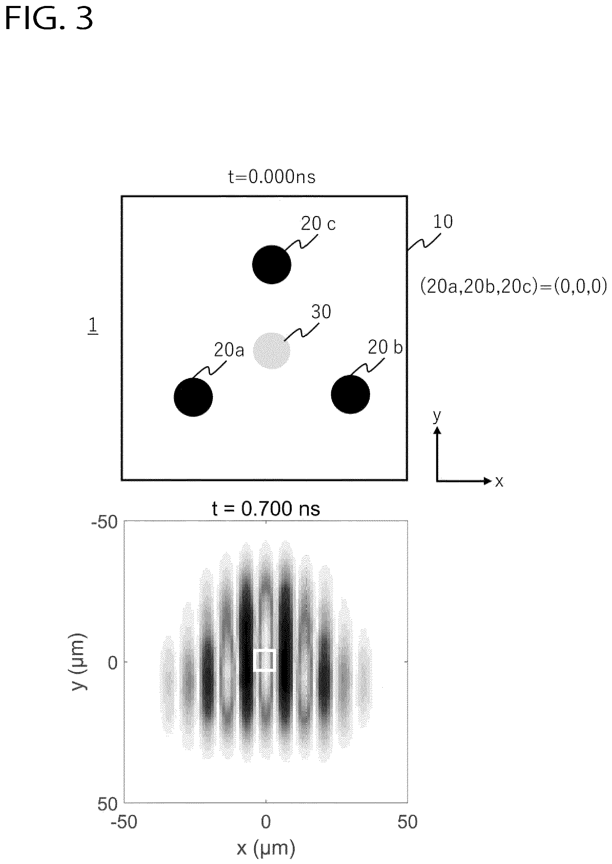

The simulation results shown in Figures 3 to 6 are used to explain the polarization state of the light irradiated to the input sections 20a, 20b and 20c and the phase of the electron spin wave after interference. The upper rows of Figures 3 to 6 show the polarization state of the light irradiated to the input sections 20a, 20b and 20c. Black circles indicate that the irradiated light is right-handed circularly polarized, i.e., phase 0 of the electron spin wave, logical value 0. White circles indicate that the irradiated light is left-handed circularly polarized, i.e., phase $\pi$ of the electron spin wave, logical value 1. The lower rows of Figs. 3 to 6 show the phase of the electron spin wave after interference, specifically 0.700 ns after irradiation. The white square shown near the center corresponds to the position of the output section 30.

Figure 3 shows the case (20a, 20b, 20c) = (0, 0, 0). In this case, as shown in the lower figure, the phase at output section 30 of the electron spin wave after interference is 0. In other words, the output section 30 reads a logical value of 0. This value is the majority value regarding (20a, 20b, 20c) = (0, 0, 0).

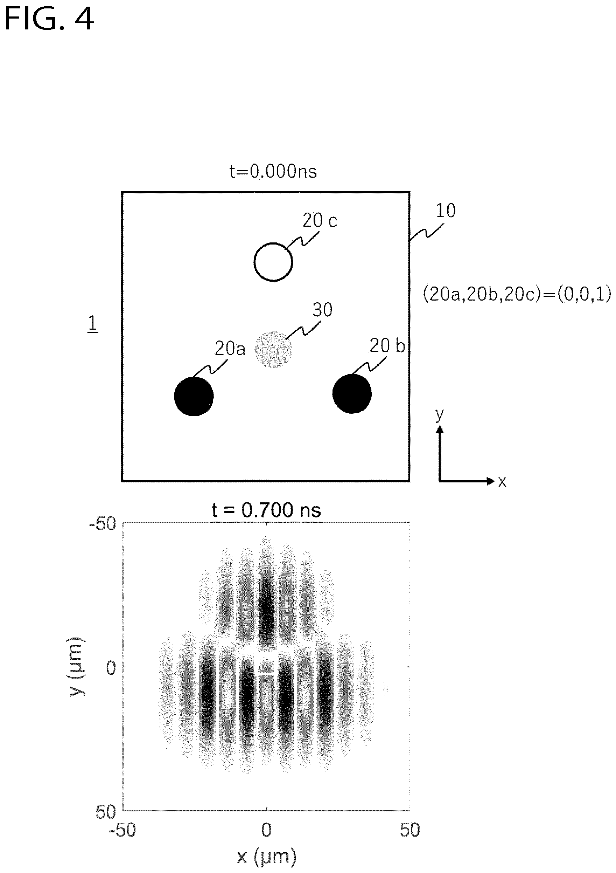

Figure 4 shows the case (20a, 20b, 20c) = (0, 0, 1). In this case, as shown in the lower figure, the phase at output section 30 of the electron spin wave after interference is 0. In other words, the output section 30 reads a logical value of 0. This value is the majority value regarding (20a, 20b, 20c) = (0, 0, 1).

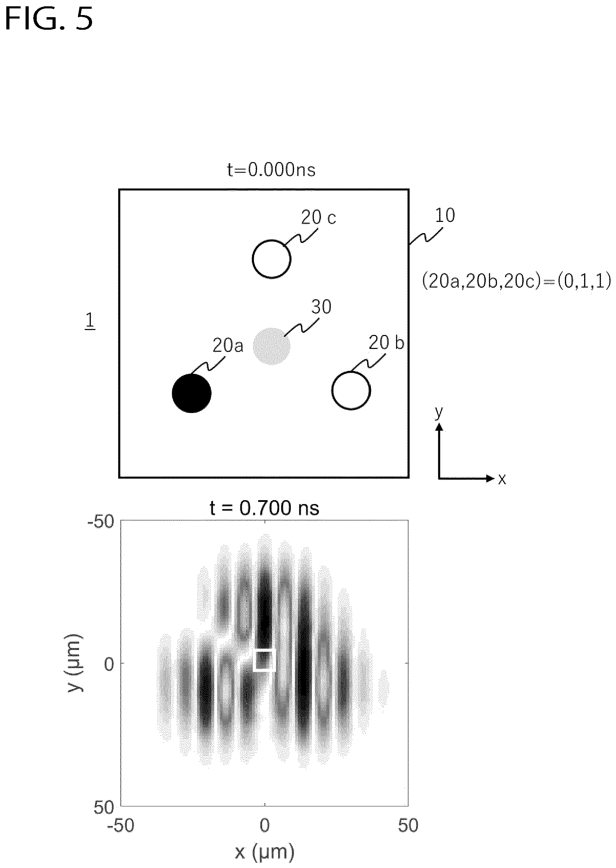

Figure 5 shows the case (20a, 20b, 20c) = (0, 1, 1). In this case, as shown in the lower figure, the phase at output section 30 of the electron spin wave after interference is $\pi$. In other words, the output section 30 reads a logical value of 1. This value is the majority value regarding (20a, 20b, 20c) = (0, 1, 1).

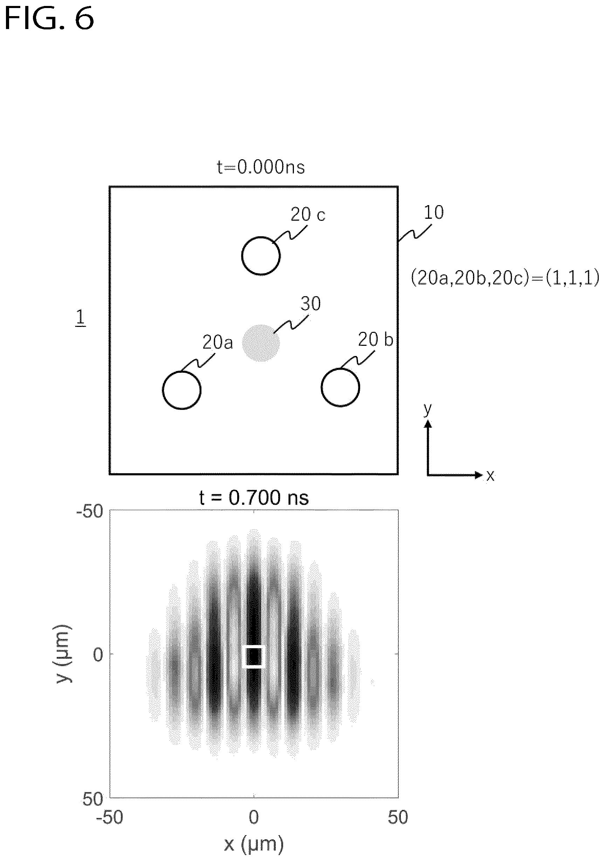

Figure 6 shows the case (20a, 20b, 20c) = (1, 1, 1). In this case, as shown in the lower figure, the phase at output section 30 of the electron spin wave after interference is $\pi$. In other words, the output section 30 reads a logical value of 1. This value is the majority value regarding (20a, 20b, 20c) = (1, 1, 1).

Thus, in Figures 3 to 6, depending on the polarization state of the light irradiated to the input sections 20a, 20b and 20c, the majority value of the logical value corresponding to that polarization state is read out by the output section 30. The same is true for (20a, 20b, 20c) = (0, 1, 0), (1, 0, 0), (1, 0, 1), (1, 1, 0), etc., although the figures are omitted.

Table 1 summarizes the relationship between the polarization state of the three lights irradiated to the input sections 20a, 20b and 20c, i.e., corresponding logical values, and the phase of the electron spin wave observed at the output section 30 after the electron spin wave interference, i.e., corresponding logical values.

[Table 1]

By arranging the input sections so that the length of the projection of the distance between adjacent input sections in the oscillating direction of the electron spin wave is an integer multiple of the wavelength of the electron spin wave, a majority logic device can be realized with regard to the polarization state of the three lights irradiated to the input sections 20a, 20b and 20c.

According to this embodiment, by providing a nonmagnetic semiconductor layer comprising a material that generates electron spin waves having different phases according to the polarization state upon irradiation of light having at least two mutually different polarization states, an optical signal having logical information represented by the polarization state can be converted into an electron spin wave having logical information represented by the spin state. Furthermore, by making the length of the projection of the distance between adjacent input sections, projected in the oscillating direction of the electron spin wave, an integer multiple of the wavelength of the electron spin wave, a majority logic circuit of the above logic signal can be realized. The input sections of this majority logic circuit can be arranged in a two-dimensional direction. Furthermore, the circuit is highly consistent with optical communications, etc., since optical signals, rather than electrical pulsed magnetic fields, etc., are used as inputs.

As explained above, according to this embodiment, it is possible to realize a majority logic device that has a high degree of freedom in circuit configuration, does not require a predetermined gap between each of the logic input sections as is the case with the technology described in Patent Literature 1, and has good consistency with optical signals.

Example 1

The electron spin wave may be an inverse Persistent Spin Helix (iPSH) generated in a two-dimensional electron gas. In this case, each input may be arranged in directions in plane of the nonmagnetic semiconductor layer 10.

For example, in a III-V semiconductor heterostructure, by equalizing the absolute value of two types of spin-orbit interactions of different origin, i.e., the absolute value of the Rashba spin-orbit interaction coefficient $\alpha$ and the absolute value of the Dresselhaus spin-orbit interaction coefficient $\beta$, it is possible to fix the direction of the effective magnetic field to one and to generate Persistent Spin Helix (broad sense) with suppressed spin relaxation. The Persistent Spin Helix (broad sense) state is a state in which the phase of the electron spin wave exhibits a stripe-like pattern, and the oscillation of the electron spin wave can be used efficiently while suppressing the diffusion of the electron spin wave. Here, the case of $\alpha = \beta$ is called Persistent Spin Helix (narrow sense), in which the phase is constant in the direction of the electron spin wave and changes in the direction orthogonal to the direction of the electron spin wave. On the other hand, the case $\alpha = -\beta$ is called inverse Persistent Spin Helix, in which the phase is constant in the direction orthogonal to the direction of the electron spin wave and changes in the direction of the electron spin wave.

The deviation between the absolute values of the Rashba spin-orbit interaction coefficient $\alpha$ and the absolute value of the Dresselhaus spin-orbit interaction coefficient $\beta$ may be within 15% of the average of the absolute values. Preferably, the deviation between the absolute value of $\alpha$ and the absolute value of $\beta$ is within 10% of the average of the absolute values. More preferably, the absolute value of $\alpha$ is equal to the absolute value of $\beta$.

Table 2 shows the previously reported Rashba spin-orbit interaction coefficient $\alpha$ and the wavelength $\lambda$ of the electron spin wave. $\lambda$ is preferably between 1 nm and 10 $\mu$m. Any of the materials can be candidates for nonmagnetic semiconductor materials for inverse Persistent Spin Helix, but materials with large $\lambda$ are preferred for ease of fabrication, and materials with small $\lambda$ are preferred for miniaturization. For example, tin sulfide, SnS, is considered useful.

[Table 2]

Example 2

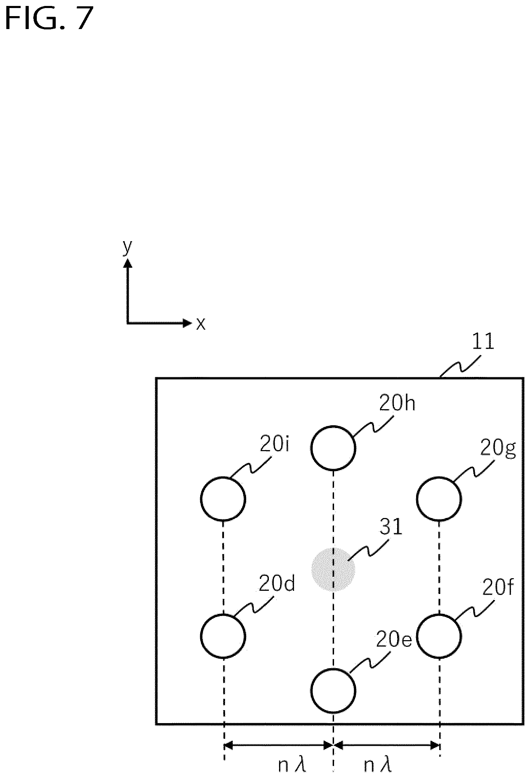

In the example in Figure 1, the input sections 20a, 20b and 20c are arranged at each vertex of an equilateral triangle. However, embodiments are not limited to this, and the input sections may be arranged in polygonal shapes other than equilateral triangles. Figure 7 shows a nonmagnetic semiconductor layer 11 in which the input sections 20d, 20e, 20f, 20g, 20h and 20i are arranged in a regular hexagonal shape and the output section 31 is placed at the center of gravity of this regular hexagon. In the nonmagnetic semiconductor layer 11, the length of the projection of the distance between adjacent input sections in the oscillating direction of the electron spin wave, i.e., x-axis direction, is an integer multiple of the wavelength of the electron spin wave, i.e., $n\lambda$ or $2n\lambda$.

Example 3

The electron spin wave may be an electron spin wave changed to a helical spin mode due to confinement of a two-dimensional electron gas in a one-dimensional fine wire structure. The electron spin wave changed to the helical spin mode includes an inverse Persistent Spin Helix state and a state in which only the Rashba spin-orbit interaction is active. Here, the state in which only the Rashba spin-orbit interaction is active means a state in which the absolute value of the Rashba spin-orbit interaction coefficient $\alpha$ is 10 times larger than the absolute value of the Dresselhaus spin-orbit interaction coefficient $\beta$. In this case, each input section may be arranged in a one-dimensional direction on the nonmagnetic semiconductor layer. For example, GsAs/AlGsAs quantum wells and InGaAs/InAlAs quantum wells can be used as one-dimensional fine wire structures in the inverse Persistent Spin Helix state. As one-dimensional fine wire structures in a state in which only the Rashba spin-orbit interaction is active, InGaAs/InAlAs quantum wells, for example, can be used.

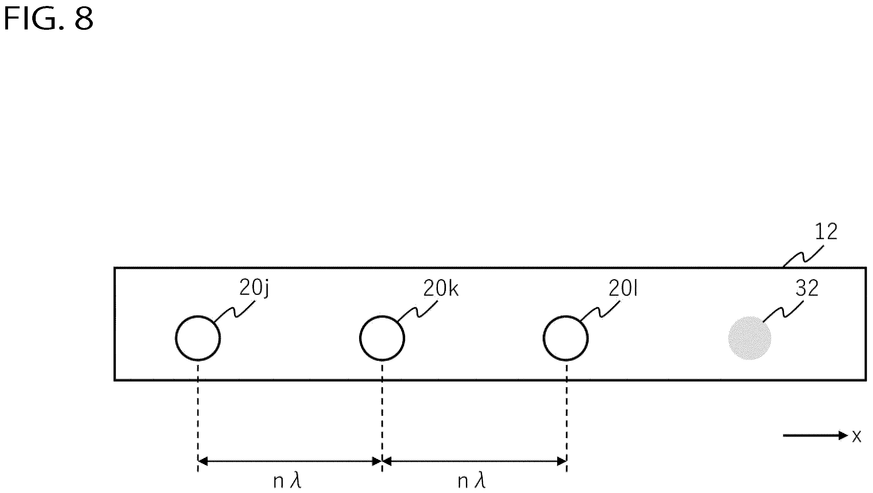

Figure 8 shows a nonmagnetic semiconductor layer 12 with input sections 20j, 20k, 20l and output section 32 arranged in a one-dimensional direction, i.e., x-axis direction. Also in the nonmagnetic semiconductor layer 12, the length of the projection of the distance between adjacent input sections in the oscillating direction of the electron spin wave, i.e., in the x-axis direction, is an integer multiple of the wavelength of the electron spin wave, $n\lambda$.

The second embodiment

Another embodiment of majority logic device further comprises a waveguide layer stacked directly or through other layers on a nonmagnetic semiconductor layer. This waveguide layer has waveguides connected to each of the three or more input sections directly or individually via other layers. The majority logic device has a mirror section for guiding light through the waveguide to the respective input section at the location where the waveguide is connected to each of the three or more input sections directly or individually via other layers, hereinafter also referred to as "end section".

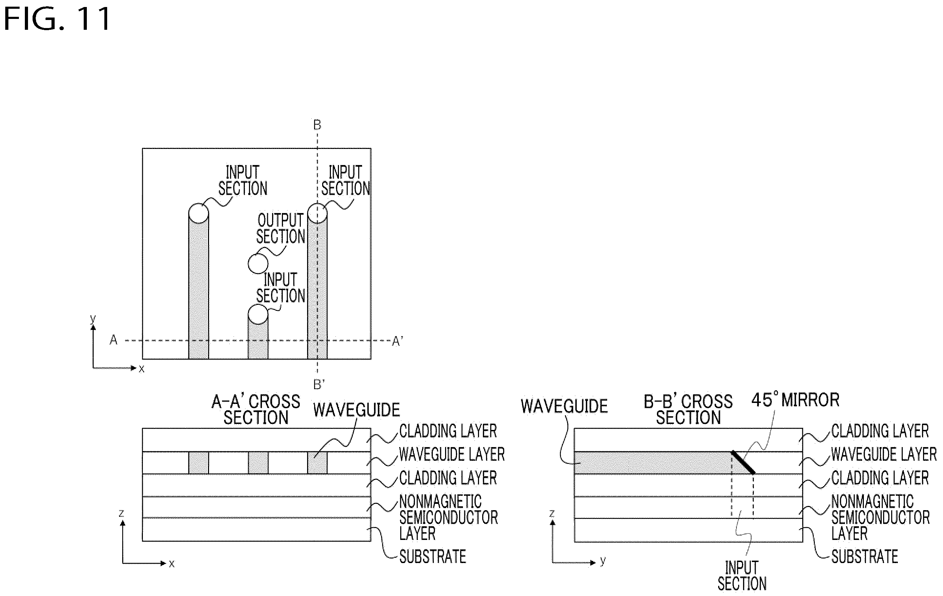

Figure 11 schematically shows a device having a non-magnetic semiconductor layer with waveguide layers stacked through other layers. This device takes a structure in which the non-magnetic semiconductor layer, cladding layer, waveguide layer, and cladding layer are sequentially stacked on the substrate. The material of the waveguide should be selected such that light of the wavelength to be used is transmitted. The materials other than waveguide portions of the waveguide layer and the cladding layer should have a lower refractive index than that of the waveguide, i.e., core, material. If the waveguide is a Si waveguide, infrared laser light may be used. In this case, $SiO_2$ may be used for the portions of the waveguide layer other than the Si waveguide and the cladding layer, and InGaAs may be used for the non-magnetic semiconductor layer. If GaAs is used for the nonmagnetic semiconductor layer, polymer waveguides formed with UV-cured resin may be used instead of Si waveguides.

When the optical signal, i.e., pump light, passes through the waveguide and comes in contact with the input sections of the nonmagnetic semiconductor layer, e.g., the three vertexes of an equilateral triangle, it is deflected by a mirror section, e.g., a 45° mirror section, and injected into the three input sections. In the nonmagnetic semiconductor layer, an electron spin wave with phase 0 is generated when the pump light is right-handed circularly polarized, and an electron spin wave with phase $\pi$ is generated when the pump light is left-handed circularly polarized. The wavelength $\lambda$ of the electron spin wave is independent of the wavelength of the pump light, see the value of $\lambda$ in Table 2. In the case of a Si waveguide, the sidewall portion and the 45° mirror portion may be formed by separate etching processes. Anisotropic etching with TMAH on the Si (001) plane and KOH on the Si (110) plane may be used to process the 45° mirror at the end section of the Si waveguide.

In this embodiment, the waveguides may be oriented in a direction that is substantially orthogonal to the oscillating direction of the electron spin wave. As discussed below, in the majority logic device according to this disclosure, the orthogonal direction, i.e., y-direction, has a greater tolerance for misalignment than the oscillating direction of the electron spin wave, x-direction. It is preferred that the waveguide be in the y-direction since the misalignment of the 45° mirror process is greater than that of the waveguide.

The third embodiment

The third embodiment is a photoelectric conversion device. In the majority logic device described above, the spin polarization of the electron spin wave is output from the output section as the output logical value. In contrast, a photoelectric conversion device with a majority logic circuit can be realized by converting this spin polarization into an electrical signal using, for example, a magnetoresistive device, i.e., MR device. In other words, this embodiment is a photoelectric conversion device comprising a majority logic device according to the first or second embodiment and a magnetoresistive device that converts the spin polarization of the output section of the majority logic device into an electrical signal.

The fourth embodiment

The fourth embodiment is an optical communication logic device. This optical communication logic device comprises a majority logic device according to the first or second embodiment and an optical output element. The optical output element may, for example, irradiate linearly polarized light as a probe light and detect changes in the polarization state of transmitted light/-reflected light due to the Faraday effect/Kerr effect. If the user wishes to use the output signal in addition to detection, the light may be polarization separated by a polarizing beam splitter, PBS, converted to an electrical signal by a photodiode or the like, and then differentially amplified, as in the case of reading a magneto-optical disk, for example.

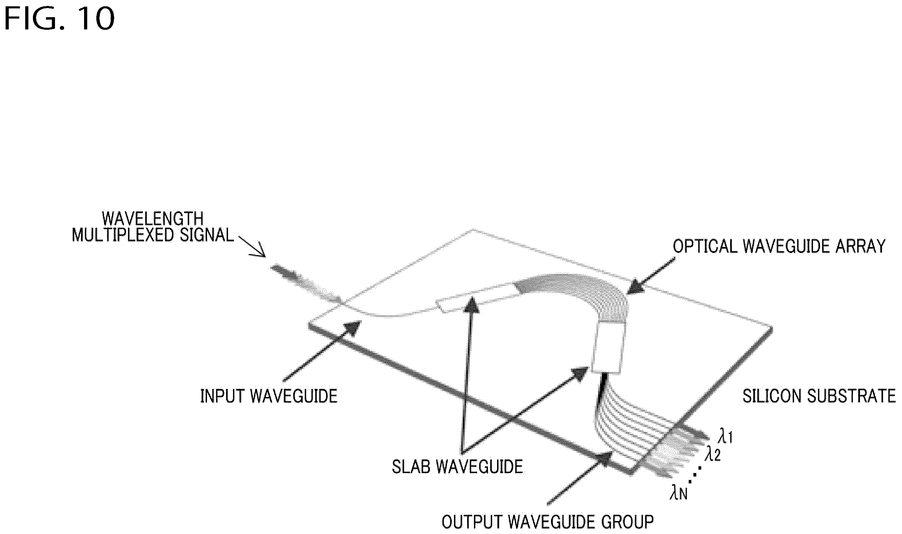

In this embodiment, the optical communication logic device may comprise a majority logic device according to the first or second embodiment and a wavelength multiplexed optical input element. The wavelength-multiplexed optical input element may be, for example, an arrayed waveguide grating, AWG, device comprising an input waveguide, a slab waveguide, an optical waveguide array, another slab waveguide and an output waveguide group, shown schematically in Figure 10. Here, the wavelength multiplexed optical input element functions as an optical demultiplexer that splits the wavelength-multiplexed optical signal into multiple single-wavelength optical signals.

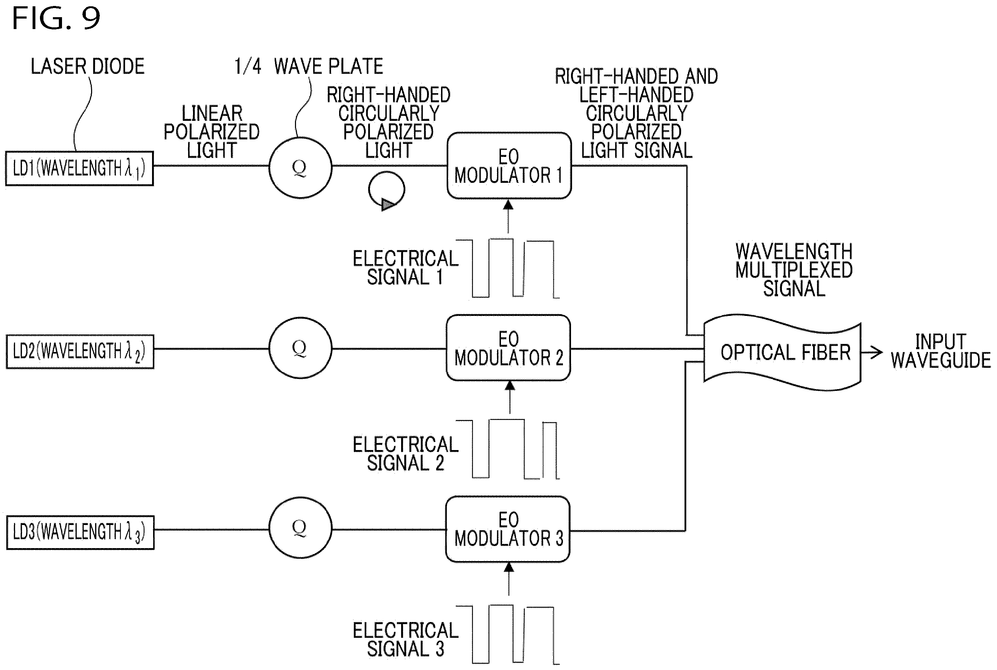

Figure 9 schematically shows the generation of wavelength-multiplexed optical signals to be input to the input waveguide of the AWG device. First, three laser diodes LD1, LD2, and LD3 emit linearly polarized laser lights with wavelengths $\lambda 1$, $\lambda 2$ and $\lambda 3$, respectively. These linearly polarized laser lights are converted into right-handed circularly polarized lights by a quarter wave plate, Q. These lights are then modulated by electrical signals 1, 2 and 3 in EO modulator 1, EO modulator 2 and EO modulator 3, respectively, to become left-handed and right-handed circularly polarized modulation signals. Each of the left-handed and right-handed circularly polarized light modulation signals is combined by an optical multiplexer, passes through an optical fiber as a wavelength-multiplexed light signal, and enters the input waveguide of the AWG device of Figure 10. This wavelength-multiplexed optical signal input to the AWG device is wavelength-separated and output, resulting in a pump light that regenerates the left and right circularly polarized modulation signals output from each EO modulator.

Figure 10 schematically shows the AWG device used in this embodiment. The entire AWG device is formed on a silicon substrate and includes an input waveguide, an optical waveguide array, two slab waveguides and an output waveguide group. Light input to the input waveguide is wavelength-separated to regenerate left and right circularly polarized modulation signals, and pump light is output from the output waveguide group. When the majority logic device is in the second embodiment, the pump light $\lambda 1$, $\lambda 2$ and $\lambda 3$ pass through the waveguides and come in contact with the input sections of the nonmagnetic semiconductor layer, e.g., the three vertexes of an equilateral triangle, they are deflected by a mirror section, e.g., a 45° mirror section, and injected into the three input sections. In the nonmagnetic semiconductor layer, an electron spin wave of phase 0 is generated when the pump light is right-handed circularly polarized, and an electron spin wave of phase $\pi$ is generated when the pump light is left-handed circularly polarized. The wavelength $\lambda$ of the electron spin wave is independent of the wavelength of the pump light, see the value of λ in Table 2.

The fifth embodiment

The fifth embodiment is a control method for a majority logic device. This majority logic device has a nonmagnetic semiconductor layer comprising a material that generates electron spin waves having a phase corresponding to the polarization state upon irradiation of light having at least two mutually different polarization states. This nonmagnetic semiconductor layer has three or more input sections for inputting optical signals and at least one output section for outputting the result of interference of electron spin waves. The length of the projection of the distance between adjacent input sections projected in the oscillating direction of the electron spin wave deviates from an integer multiple of the wavelength of the electron spin wave within 25% of the wavelength. This majority logic device uses the optical signal modulated with right-handed and left-handed circular polarization.

The majority logic device can be controlled in various ways.

Control Example 1

Consider the case in which the plurality of input sections of the above majority logic device has a first input section and a second input section, and the distance between the first input section and the output section is longer than the distance between the second input section and the output section. In this case, the device may be controlled to compensate so that the intensity of the optical signal input to the first input section is greater than the intensity of the optical signal input to the second input section. By controlling the majority logic device in this manner, the difference in attenuation of the optical signal due to the difference in distance between the input and output sections can be compensated.

Control Example 2

At least one of the multiple input sections of the above majority logic device may be controlled to input an optical signal that is always either right-handed circularly polarized or left-handed circularly polarized. For example, by inputting an optical signal that is always right-handed circularly polarized, i.e., logical value 0, to one of the three input sections, an AND circuit with the remaining two input sections can be realized. Or, by inputting an optical signal of always left-handed circularly polarized light, i.e., logical value 1, to one of the three input sections, an OR circuit with the remaining two input sections can be realized. Furthermore, in order to realize a majority logic circuit comprising an even number of input sections that outputs the higher number of inputs when the number of inputs is not equal between 0 and 1, and outputs 0 when the number of inputs is equal between 0 and 1, one additional input section can be controlled to input an optical signal of always right-handed circularly polarized light, i.e., logical value 0.

According to this control example, various types of logic circuits can be realized.

The invention has been described above in terms of embodiments. It is understood by those skilled in the art that these embodiments are examples, that various variations are possible in the combination of their respective components and respective processing processes, and that such variations are also within the scope of the invention.

Variant 1

In the above embodiment, the length of the projection of the distance between adjacent input sections projected in the oscillating direction of the electron spin wave is an integer multiple of the wavelength of the electron spin wave. However, it is believed that this length does not necessarily have to be an exact integer multiple of the electron spin wave wavelength. To verify this, the inventors performed the following simulations.

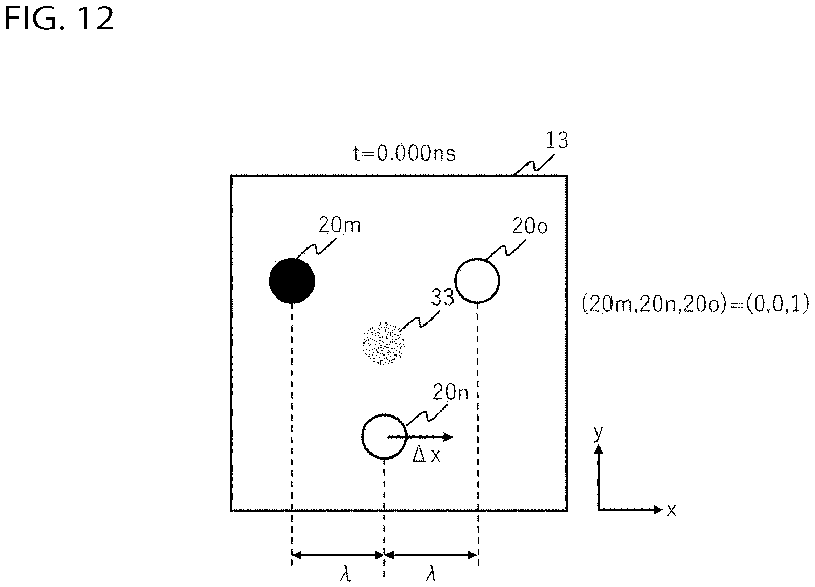

Figure 12 shows a non-magnetic semiconductor layer 13 comprising input sections 20m, 20n, 20o and output section 33, as in Figure 1. The input sections 20m, 20n and 20o are located at each vertex of an equilateral triangle, and the output section 33 is located at the center of gravity of this equilateral triangle. The length of the projection of the distance between the input sections 20m and 20n and the distance between the input sections 20n and 20o in the oscillating direction of the electron spin wave, x-axis direction, is λ. In Figure 12, the arrangement is upside down from Figure 1, but there is no essential difference between the two. Black circles indicate that the irradiated light is right-handed circularly polarized, phase 0 of the electron spin wave, logical value 0. White circles indicate that the irradiated light is left-handed circularly polarized, phase π of the electron spin wave, logical value 1. In the initial state of Figure 12, i.e., time t = 0.000 ns, the polarization state is (20m, 20n, 20o) = (0, 1, 1).

In the following, consider the case in which the input section 20n is shifted by $\Delta x$ in the x direction. We will check by simulation whether a majority logic circuit can be correctly realized when the placement of the inputs 20m, 20n and 20o is shifted from an equilateral triangle.

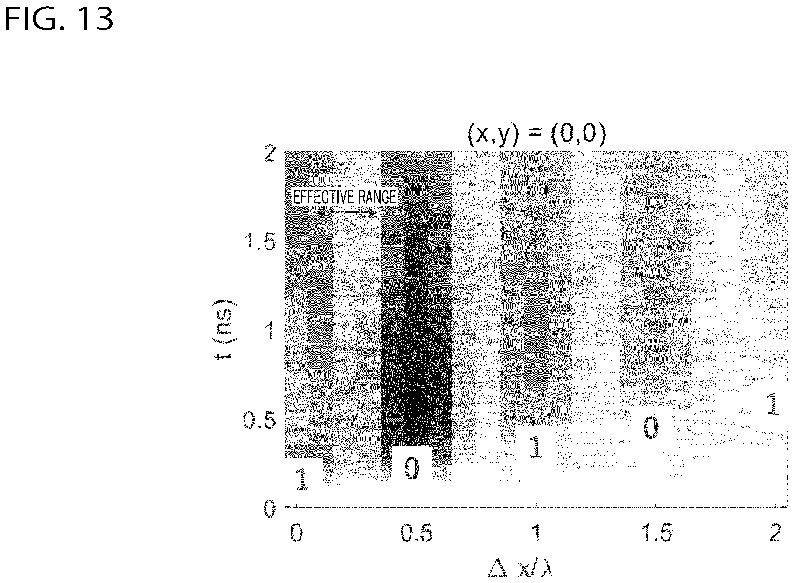

Figure 13 shows the simulation results of the time evolution of the phase of the electron spin wave at (x, y) = (0, 0) when the input section 20n is varied in the x direction. The ratio $\Delta x/\lambda$, i.e., the ratio of the deviation $\Delta x$ of the input section 20n to the wavelength $\lambda$, is taken on the horizontal axis, and the time t(ns) is taken on the vertical axis. As shown in the figure, for $\Delta x/\lambda$ = 0, 1 and 2, the phase of the electron spin wave is π, i.e., the logical value is 1 (in this case, the majority logic is correctly established), for $\Delta x/\lambda$ = 0.5 and 1.5, the phase of the electron spin wave is 0, i.e., the logical value is 0 (in this case, the majority logic is not correctly established.)

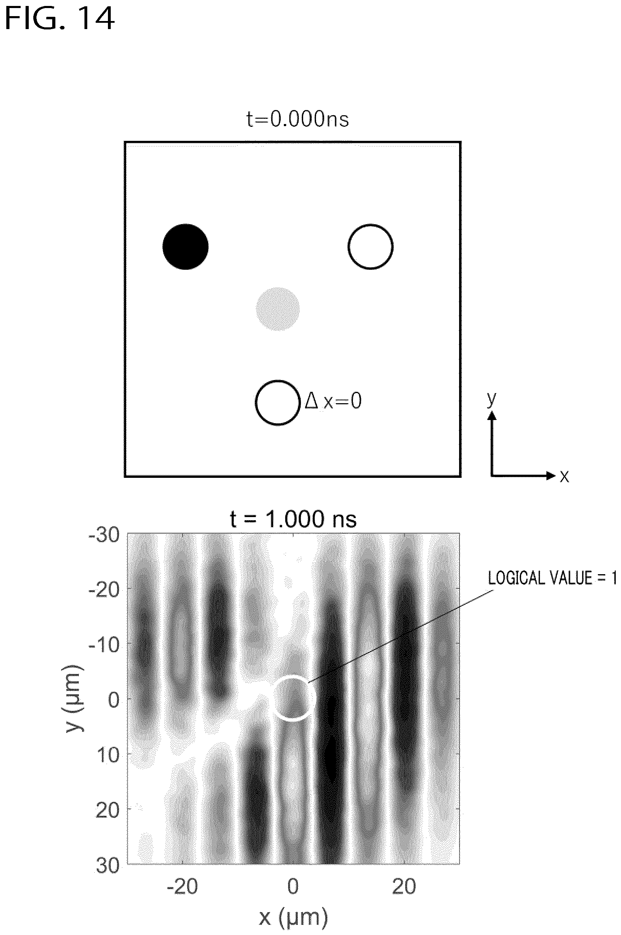

Figure 14 shows the polarization state of the light irradiated to the input sections 20m, 20n and 20o, and the phase of the electron spin wave after interference when $\Delta x = 0$. The upper row shows the polarization state of the light irradiated to each input section. The lower row shows the phase of the electron spin wave after interference (time t = 1.000ns), the white circle shown near the center corresponds to the position of 33 output sections. As illustrated, after the interference of the electron spin waves, the logical value at the position of the output section 33 is 1. This indicates that majority logic is realized for (20m, 20n, 20o) = (0, 1, 1).

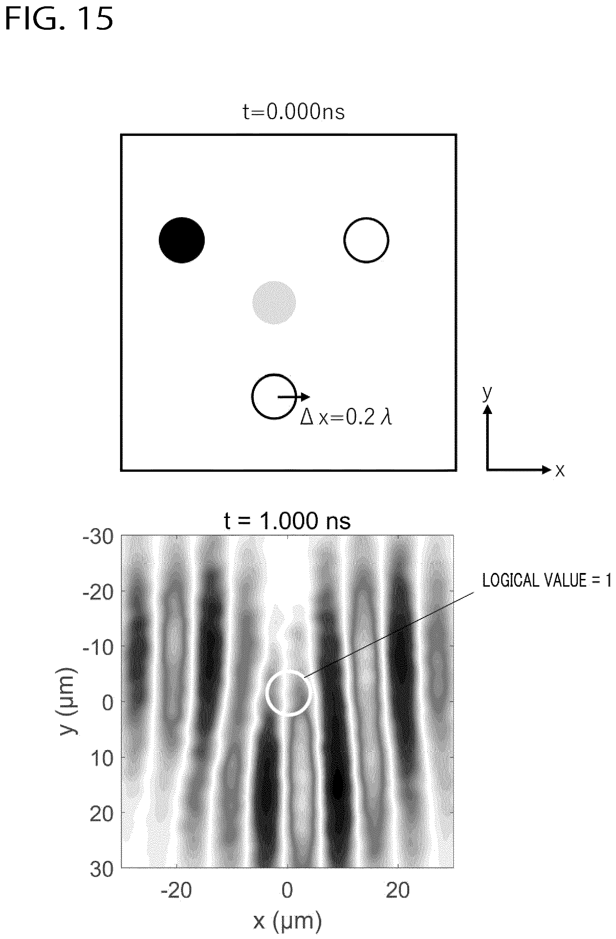

Figure 15 shows the polarization state of the light irradiated to the input sections 20m, 20n and 20o, and the phase of the electron spin wave after interference when $\Delta x = 0.2\lambda$. As illustrated, after the interference of the electron spin waves, the logical value at the position of the output section 33 is 1. Therefore, it can be seen that the majority logic is realized for (20m, 20n, 20o) = (0, 1, 1) in this case as well.

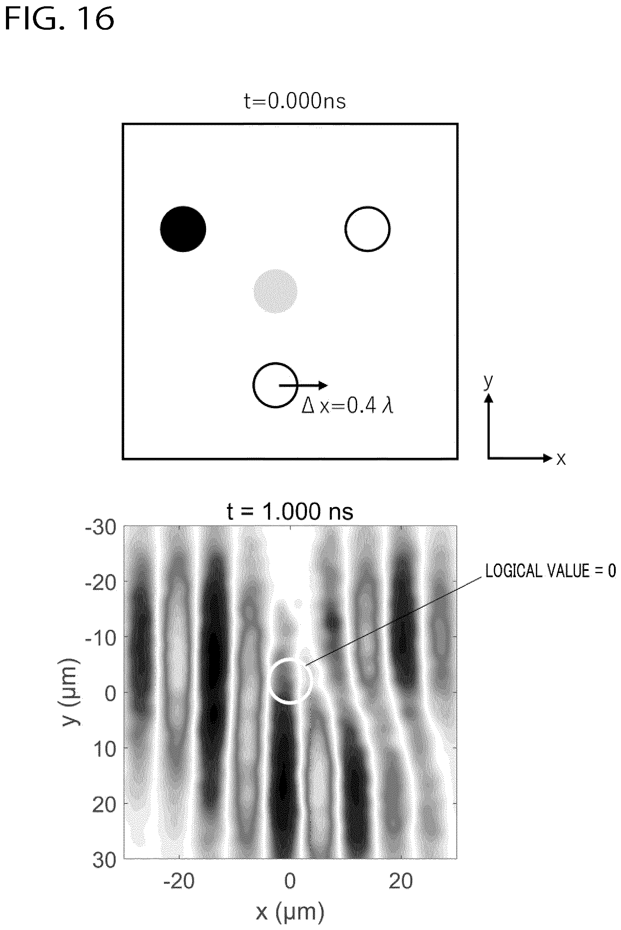

Figure 16 shows the polarization state of the light irradiated to the input sections 20m, 20n and 20o, and the phase of the electron spin wave after interference when $\Delta x = 0.4\lambda$. As illustrated, after the interference of the electron spin waves, the logical value at the position of the output section 33 is 0. Therefore, in this case, the majority logic is not correctly realized for (20m, 20n, 20o) = (0, 1, 1) and an error has occurred.

As can be seen from the above simulation results, it is expected that with such an equilateral triangle arrangement, even if one of the input sections is shifted in the x-direction by, e.g., 25%, the majority logic circuit can be realized correctly.

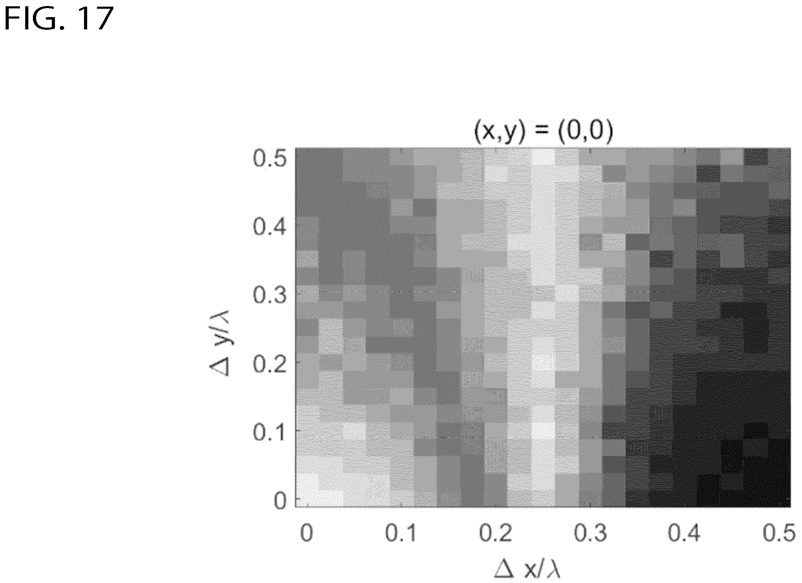

Next, Figure 17 shows the simulation results of the phase of the electron spin wave at (x, y) = (0, 0) when the input section 20n is shifted in the x and y directions. The ratio $\Delta x/\lambda$ of the misalignment $\Delta x$ in the x direction to the wavelength $\lambda$ is taken on the horizontal axis, and the ratio $\Delta y/\lambda$ of the misalignment $\Delta y$ in the y direction to the wavelength $\lambda$ is taken on the vertical axis.

As illustrated, for misalignment in the x-direction, the phase changes and reverses every half wavelength. On the other hand, for misalignment in the y direction, the phase does not change, but only the amplitude does. Therefore, with respect to the realization of majority logic circuits, misalignment in the y-direction is considered to be relatively more tolerable than misalignment in the x-direction.

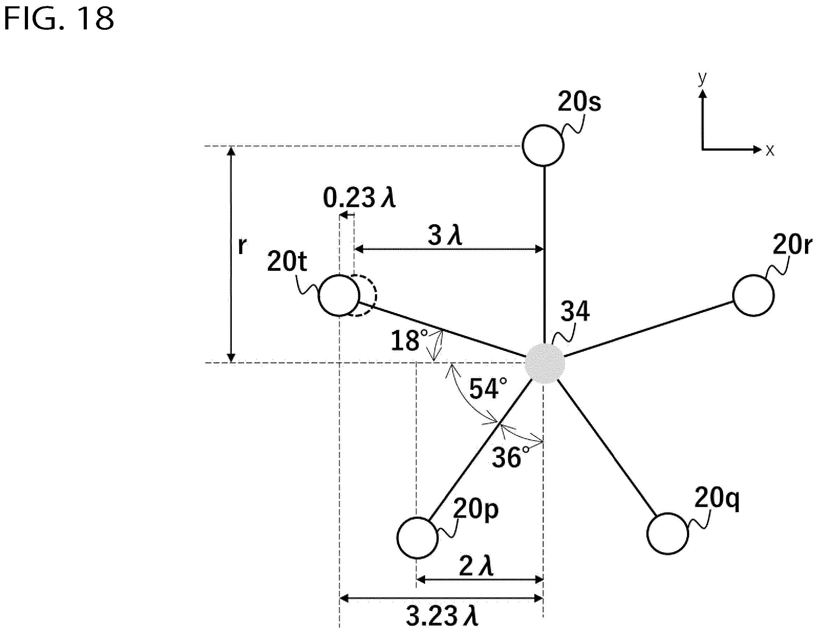

Figure 18 shows an example in which the five input sections 20p, 20q, 20r, 20s and 20t are placed at each vertex of a regular pentagon and the output 34 is placed at the center of gravity of the regular pentagon. Let us assume that the length of the projection of the distance between the input sections 20p and 20s projected in the oscillating direction of the electron spin wave, x-axis direction, is twice the wavelength of the electron spin wave $\lambda$, i.e., $2\lambda$. Let r be the distance between the center of each input section, i.e., each vertex of a regular pentagon, and the center of the output section 34, i.e., center of gravity of a regular pentagon. Then,

$$2\lambda = r \cos 54°.$$

In this case, the length of the projection of the distance between the input sections 20t and 20s in the oscillating direction of the electron spin wave, i.e., x-axis direction, is,

$$r \cos 18° \approx 3.23\lambda.$$

In other words, the length of the projection of the distance between the input sections 20t and 20s in the oscillating direction of the electron spin wave, i.e., x-axis direction, is shifted by about $0.23\lambda$ in the x direction from the integer multiple of the nearest wavelength, i.e., $3\lambda$. This deviation, i.e., about 23% of the wavelength $\lambda$, is within 25% of the wavelength $\lambda$. Therefore, it is believed that a majority logic circuit can be correctly realized even when each input section is placed at each vertex of a regular pentagon in this manner.

Variant 2

In the previous examples, the output section is set at a position where the length of the projection of the distance between the output section and the input section in the oscillating direction of the electron spin wave is an integer multiple of the wavelength of the electron spin wave. In contrast, the output section can be set at a position where the length of the projection of the distance between the output section and the input section in the oscillating direction of the electron spin wave is an integer +1/2 multiple of the wavelength of the electron spin wave. This allows the output to be obtained with NOT acting on the majority logic. In this case, if necessary, the difference in attenuation of the optical signal due to the difference in distance between the input and output sections, as described in Control Example 1, may be compensated.

Furthermore, it is possible to use two or more output sections to obtain a majority logic output and the NOT output simultaneously, or to combine two or more outputs to improve accuracy.

The sixth embodiment

In a one-dimensional fine wire structure formed by semiconductor quantum wells, electron spin waves with a fixed phase state can be generated by irradiating polarized light to electrons in the one-dimensional fine wire structure. The electron spin wave with a defined phase state can also be input from an adjacent one-dimensional fine wire structure. The generated or input electron spin wave propagates in the one-dimensional fine wire structure. The electron spin wave can take on the following states, depending on the type and magnitude of the spin-orbit interaction acting on it.

The PSH, i.e., Persistent Spin Helix, state is realized when the strength of the Rashba spin-orbit interaction, $\alpha$, is equal to the strength of the Dresselhaus spin-orbit interaction, $\beta$, i.e., $\alpha = \beta$. In this case, the direction of the effective magnetic field created by the spin-orbit interaction is constant regardless of the direction of electron motion. Therefore, the precession of the spins is not affected by the scattering of electrons, and the spin relaxation is suppressed. Specifically, coherent spin rotation persists in the [1 -1 0] direction of the crystal, while spin relaxation is suppressed in the [1 1 0] direction perpendicular to the aforementioned direction of the crystal, where the spin direction propagates without rotation.

The iPSH, i.e., inverse Persistent Spin Helix, state is realized when the sign of the strength of the Rashba spin-orbit interaction flips and becomes equal to the strength of the Dresselhaus spin-orbit interaction, i.e., $\alpha = -\beta$. In this iPSH state, the direction of the effective magnetic field changes by 90 degrees with respect to the PSH state, changing from a spin precession state to a non-spin precession state. Specifically, the spin direction propagates without rotation in the [1 -1 0] direction of the crystal, and coherent rotation of the spins is persistent in the [1 1 0] direction perpendicular to the aforementioned direction of the crystal.

In the above description, the PSH, Persistent Spin Helix, state is the state in which $\alpha = \beta$, and the iPSH state is the state in which $\alpha = -\beta$. In the actual embodiment, the absolute values of $\alpha$ and $\beta$ do not have to be exactly equal in both PSH and iPSH states. For example, in the experimental example of realizing PSH in Non-Patent Literature 3, $\alpha$ and $\beta$ are, respectively, $\alpha = (1.6\_2.3) \times 10^{-13}$ eVm and $\beta_1 - \beta_3 = (1.9\_2.6) \times 10^{-13}$ eVm., therefore, the magnitudes of their absolute values deviate by more than 10%. It should be noted that $\beta$ is defined as $\beta_1 - \beta_3$ in Non-Patent Literature 3. However, in this case, a stripe-shaped spin pattern can still be formed, which is a PSH condition. Therefore, even if the absolute values of $\alpha$ and $\beta$ deviate by about 10%, the PSH and iPSH states can be realized. Furthermore, the inventors have found that a deviation of the absolute values of $\alpha$ and $\beta$ within about 15% is acceptable.

Another characteristic state is a state in which only the Rashba spin-orbit interaction works as a spin-orbit interaction, i.e., $|\alpha| \geq 10|\beta|$.

Here, the strength of the Dresselhaus spin-orbit interaction, $\beta$, is an intrinsic value determined by the material, while the strength of the Rashba spin-orbit interaction, $\alpha$, is a value that varies with the carrier concentration. The carrier concentration can be controlled by the amount of impurities doped into the one-dimensional fine wire structure, or by providing an electrode on the one-dimensional fine wire structure and applying a voltage to the electrode. The following are two aspects.

The first aspect is a one-dimensional fine wire structure in which the spin-orbit interaction, which is the iPSH state, is active. In this case, a quantum well with a one-dimensional fine wire structure in which electrons propagate in the interior has the [1 1 0] direction of the crystal along the long axis, i.e., the x-axis, and the [1 - 1 0] direction along the y-axis orthogonal to the x-axis. When the one-dimensional fine wire structure is in the iPSH state, the electrons propagate while maintaining a coherent rotation of spins. In the first aspect, the distance means the distance projected in the x direction.

The second aspect is a one-dimensional fine wire structure in which only the Rashba spin-orbit interaction is active. In this case, the long axis, i.e., x-axis, can be defined independently of the crystal orientation, and the y-axis can be taken in the direction perpendicular to the x-axis; when the one-dimensional fine wire structure is in a state in which only the Rashba spin-orbit interaction is active, the electron propagates while maintaining coherent rotation of spins. In the second aspect, the distance means the distance on the xy-plane.

Such one-dimensional fine wire structures can be fabricated as follows, e.g., Non-Patent Literature 2. Specifically, in the example of Non-Patent Literature 2, the InAlAs/InGaAs/InAlAs quantum well structures are epitaxially grown on an InP substrate using metal organic chemical vapor deposition, MOCVD, method, and then one-dimensional fine wire structures in the [1 1 0] direction are fabricated by photolithography and etching. The films are stacked in the following order from the InP substrate.

> 200 nm $In_{0.52}Al_{0.48}As$
> 6nm $In_{0.52}Al_{0.48}As$ (Si doped at 1.2 x $10^{18}cm^{-3}$)
> 6nm $In_{0.52}Al_{0.18}As$
> 7nm $In_{0.53}Ga_{0.47}As$ Quantum well
> 6nm $In_{0.52}Al_{0.48}As$
> 6nm $In_{0.52}Al_{0.48}As$ (Si doping at 3.2$\times 10^{18}cm^{-3}$)
> 10nm $In_{0.52}Al_{0.48}As$
> Here gate insulating layer (5nm $Al_2O_3$/95nm $HfO_2$) and gate electrode (10nm Cr/100nm Au) are used. The carrier concentration for iPSH state is $1.23 \times 10^{16}m^{-2}$.

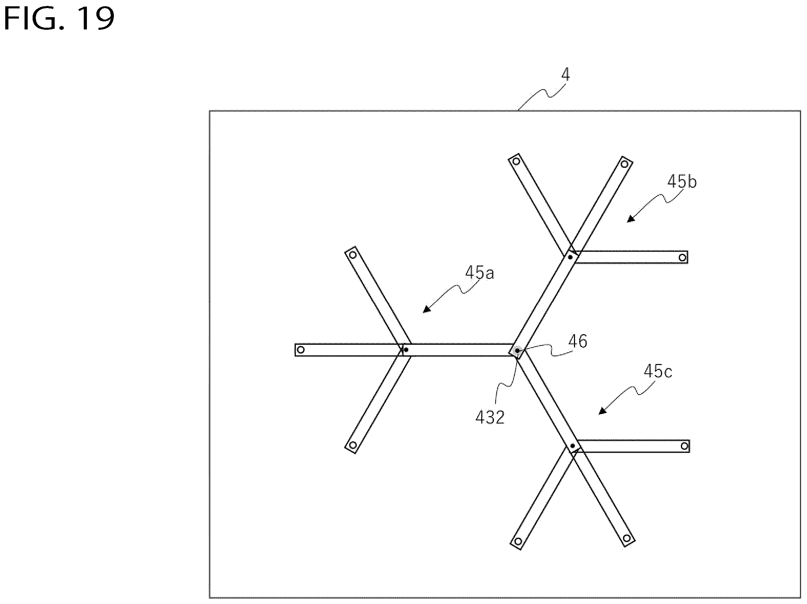

The first aspect, iPSH state, is described below. Figure 19 schematically shows a majority logic device 2 in this aspect, the sixth embodiment. The one-dimensional fine wire structures for signal input 40a, 40b and 40c comprise input sections 41a, 41b and 41c, respectively, which input optical signals before the junction point 42. The one-dimensional fine wire structures for signal input meet at the junction point to form a two-dimensional wire structure.

At the junction point 42, an output section 43 is provided that outputs the result of interferences of the electron spin waves.

The length of the projection of the distance between the junction point 42 and the respective input sections 41a, 41b, 41c of the one-dimensional fine wire structures for signal input 40a, 40b, 40c in the oscillating direction of the electron spin wave is an integer multiple of the wavelength λ. In the example in Figure 19, the lengths of the projection of the distances between the respective input sections 41a, 41b and 41c of the one-dimensional fine wire structures for signal input 40a, 40b and 40c projected in the oscillating direction of the electron spin wave are lλ, mλ and nλ, respectively. Here, l, m, and n are natural numbers respectively. For example, for a circumference of radius 2λ centered at the junction point 42, the intersection of the circumference with a straight line passing through the junction point and extending in the direction of the X axis should be 41a, and the intersection of the circumference with two straight lines passing through the junction point and making a 60° angle with the X axis should be 41b and 41c.

Thus, by making the length of the projection of the distance between the junction point 42 and each of the input sections 41a, 41b and 41c of the one-dimensional fine wire structures for signal input 40a, 40b and 40c such that the length projected in the oscillating direction of the electron spin wave is an integral multiple of the wavelength of the electron spin wave, it is possible to realize a majority logic device regarding the polarization state of the three lights irradiated to the inputs 41a, 41b and 41c.

In this aspect, the deviation between the absolute value of the Rashba spin-orbit interaction coefficient α and the absolute value of the Dresselhaus spin-orbit interaction coefficient β may be within 15% of the average of the absolute values. Preferably, the deviation between the absolute value of α and the absolute value of β is within 10% of the average of the absolute values. More preferably, the absolute value of α is equal to the absolute value of β.

According to this embodiment, a majority logic circuit can be realized using a one-dimensional fine wire structure with a non-magnetic semiconductor layer comprising a material that generates electron spin waves having different phases depending on the polarization state upon irradiation of light having at least two mutually different polarization states.

The length of the projection of the distance between the respective input sections 41a, 41b and 41c of the one-dimensional fine wire structures 40a, 40b and 40c for signal input, projected in the oscillating direction of the electron spin wave, should be an integer multiple of the wavelength λ. However, this may deviate slightly from an integer multiple of the wavelength. As shown in Variant 1 above, even if this length deviates from an integer multiple of the wavelength by about 25%, it is expected that a majority logic circuit can be correctly realized.

In the example of Fig. 19, majority logic device 2 comprises a one-dimensional fine wire structure for three signal inputs. However, this number of wires is not limited to three, but may be any odd number of wires over three.

The Seventh Embodiment

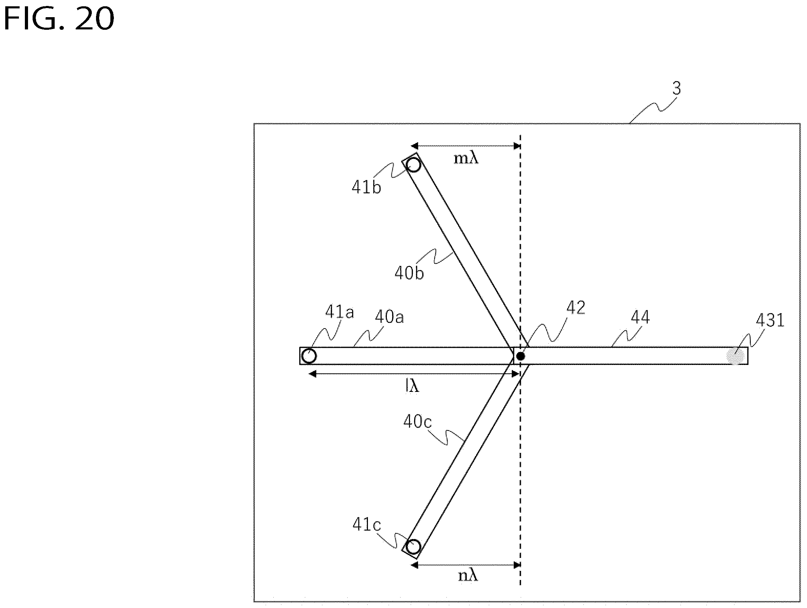

Figure 20 schematically shows the majority logic device 3 according to the seventh embodiment. Majority logic device 3 comprises three one-dimensional fine wire structures 40a, 40b, 40c for signal input and a one-dimensional confluent fine wire structure 44 extending from a junction point 42. In majority logic device 3, the output section 431 is provided in the one-dimensional confluent fine wire structure 44 instead of the output section 43 provided in the junction point 42 of majority logic device 2 in Figure 19. Other configurations of majority logic device 3 are common to those of majority logic device 2.

According to this embodiment, the degree of freedom of output positions can be increased in majority logic circuits using a one-dimensional fine wire structure for signal input.

The Eighth Embodiment

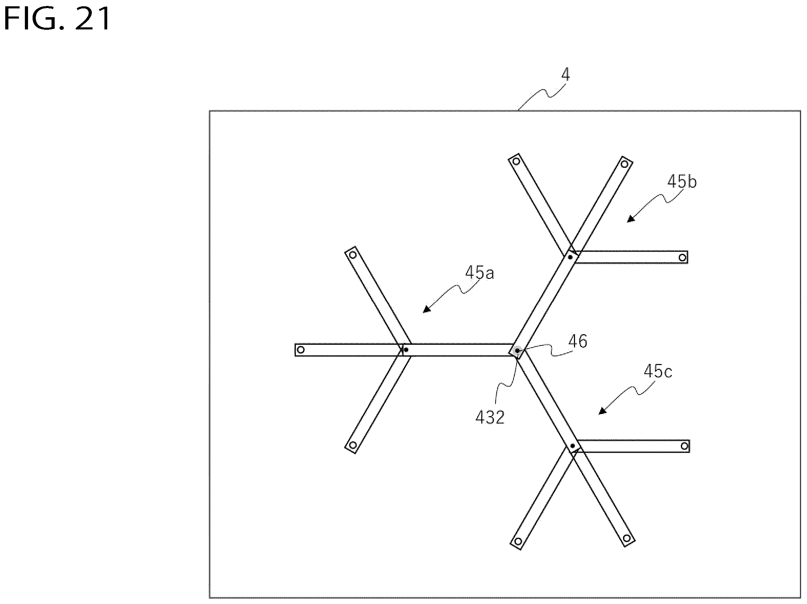

Figure 21 schematically shows the eighth embodiment of majority logic device 4. Majority logic device 4 comprises a plurality of majority logic devices 3 according to the seventh embodiment. Hereinafter, the plurality of majority logic devices 3 constituting this embodiment are referred to as "cellular majority logic devices". In other words, majority logic device 4 comprises three cellular majority logic devices 45a, 45b and 45c.

The one-dimensional confluent fine wire structures of the three cellular majority logic devices meet at a single junction point 46. Hereinafter, the point at which all cellular majority logic devices in this structure meet is referred to herein as the "final junction point". In other words, the one-dimensional confluent fine wire structures of the cellular majority logic devices 45a, 45b and 45c meet at one final junction point 46.

At the final junction point 46, an output section 432 is provided that outputs the results of interference of the electron spin waves.

In the example in Figure 21, the majority logic device 4 comprises three cellular majority logic devices. However, this number is not limited to three, and any number of cellular majority logic devices may be used.

According to this embodiment, the majority logic devices can be realized with respect to the polarization state of the light irradiated to the input section of each cellular majority logic device.

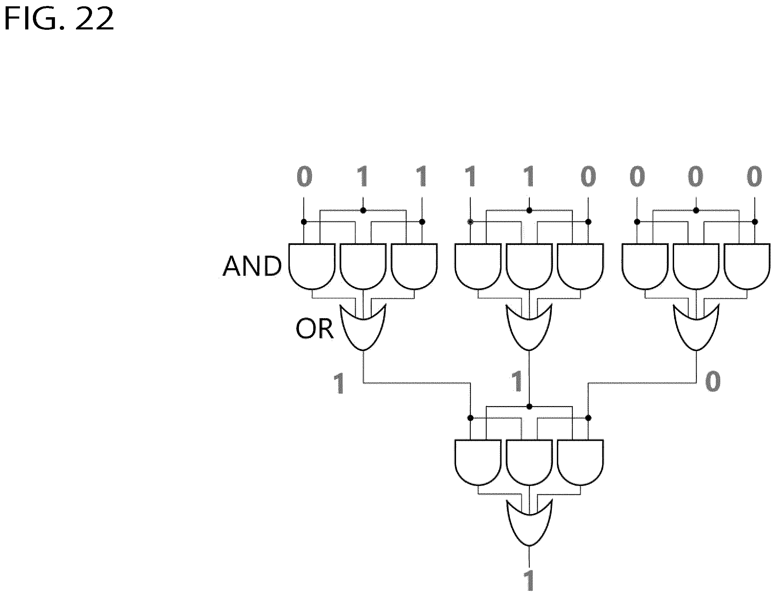

For comparison, Figure 22 shows a conventional 9-input majority logic device formed using AND OR circuits. This 9-input majority logic device comprises four 3-input majority logic devices. In this configuration, the calculation results, i.e., majority results, output from the three first-stage 3-input majority logic devices are input to the second-stage 3-input majority logic device to output the final majority result. However, in this case, as illustrated in the figure, if, for example, five 0s and four 1s are input, the final majority result should correctly output 0, but the wrong result, 1, is output. This is an unavoidable issue in multistage digital circuits.

In contrast, according to this embodiment, the correct result can be obtained no matter which input section of the majority logic device 4 in Figure 21, for example, is used to input a value. This is an advantage due to the use of the interference of electron spin waves generated by the optical signal, which cannot be realized in a multistage digital circuit.

The Ninth Embodiment

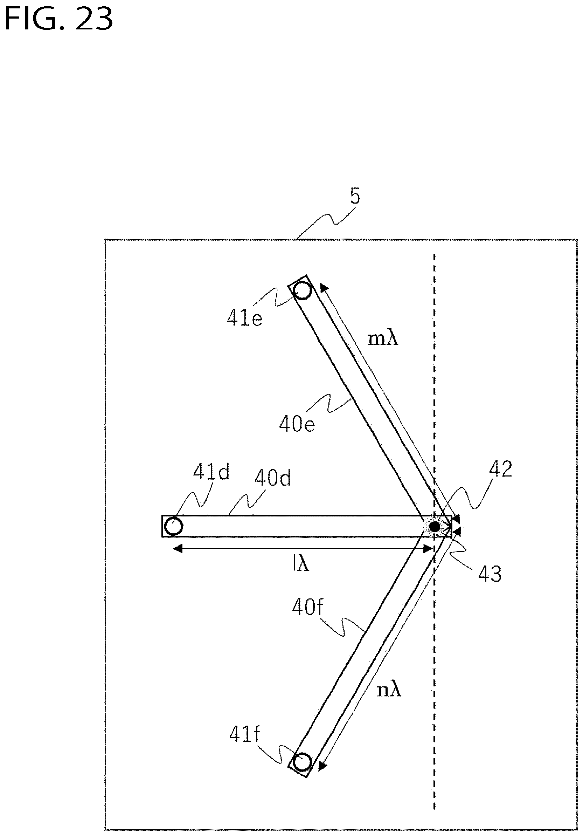

The second aspect, in which only the Rashba spin-orbit interaction is active, is described. Figure 23 schematically shows a majority logic device 5 according to this embodiment, i.e., the ninth embodiment. The majority logic device 5 comprises three one-dimensional fine wire structures 40d, 40e and 40f, for signal input. The one-dimensional fine wire structures 40d, 40e and 40f for signal input have input sections 41d, 41e and 41f, respectively, which input optical signals before the junction point 42.

The junction point 42 comprises an output section 43 that outputs the result of the interference of the electron spin waves.

The distance in the XY plane between the junction point 42 and the respective input sections 41d, 41e and 41f of the one-dimensional fine wire structures 40d, 40e and 40f for signal input is an integer multiple of the wavelength $\lambda$. In the example in Figure 23, the distances in the XY plane to the respective input sections 41d, 41e and 41f of the one-dimensional fine wire structures 40d, 40e and 40f for signal input are $l\lambda$, $m\lambda$ and $n\lambda$, respectively. Here, l, m and n are natural numbers respectively. For example, for a circumference of radius $2\lambda$ centered at the junction point 42, the input points 41d, 41e and 41f can be the intersection of an arbitrary line through the junction point and the circumference.

In the second aspect, the lifetime, i.e., relaxation time, of the electron spin wave is shorter than in the first aspect, but the number of one-dimensional fine structures to be assembled at the junction point can be increased. Therefore, in the first aspect, as shown in Fig. 21, 9 inputs must be implemented with 3 inputs and 2 stages using a cellular majority logic device, but in the second aspect, 9 inputs can be implemented with 9 inputs and 1 stage.

The Tenth Embodiment

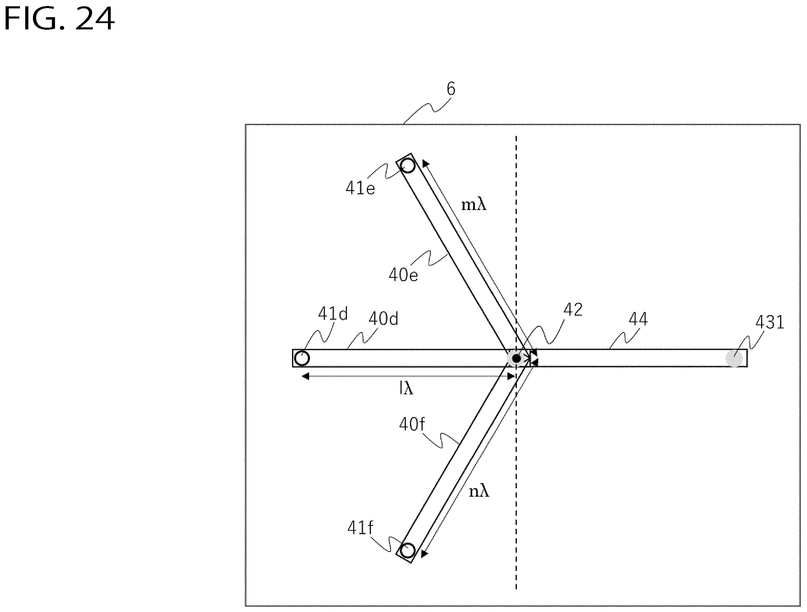

Figure 24 schematically shows a majority logic device 6 according to the tenth embodiment. The majority logic device 6 comprises three one-dimensional fine wire structures 40d, 40e, 40f for signal input and a one-dimensional confluent fine wire structure 44 extending from a junction point 42. In majority logic device 6, the output section 431 is provided in the one-dimensional confluent fine structure 44 instead of the output section 43 provided in the junction point 42 of majority logic device 5 in Figure 23. The other configurations of majority logic device 6 are common to those of majority logic device 5.

According to this embodiment, the degree of freedom of output positions can be increased in majority logic circuits using a one-dimensional fine wire structure for signal input.

Any combination of the above mentioned embodiments and variations is also useful as an embodiment of the invention. The new embodiment resulting from the combination will have the combined effects of each of the embodiments and variations combined.

The above is a description of the embodiments and variations. In understanding the technical ideas abstracted from the embodiments and variations, the technical ideas should not be interpreted as limited to the contents of the embodiments and variations. The aforementioned embodiments and variations are merely concrete examples, and many design changes, such as changes, additions, and deletions of components, are possible. In the embodiments, the contents where such design changes are possible are emphasized with the notation "embodiments". However, design changes are also allowed for contents without such notation.

INDUSTRIAL APPLICABILITY

The technology of the present disclosure can be used in the fields of optical communications, photoelectric conversion systems, network computers, and the like. Description of the code.

REFERENCE SIGNS LIST

1 Majority logic device,
2 Majority logic device,
3 Majority logic device,
4 Majority logic device,
5 Majority logic device,
6 Majority logic device,
10 Nonmagnetic semiconductor layer,
11 Nonmagnetic semiconductor layer,
12 Nonmagnetic semiconductor layer,
13 Nonmagnetic semiconductor layer,
20a Input section,
20b Input section,
20c Input section,
20d Input section,
20e Input section,
20f Input section,
20g Input section,
20h Input section,
20i Input section,
20j Input section,
20k Input section,
20l Input section,

20m Input section,
20n Input section,
20o Input section,
20p Input section,
20q Input section,
20r Input section,
20s Input section,
20t Input section,
30 Output section,
31 Output section,
32 Output section,
33 Output section,
34 Output section,
40a One-dimensional fine wire structure for signal input,
40b One-dimensional fine wire structure for signal input,
40c One-dimensional fine wire structure for signal input,
40d One-dimensional fine wire structure for signal input,
40e One-dimensional fine wire structure for signal input,
40f One-dimensional fine wire structure for signal input,
41a Input section,
41b Input section,
41c Input section,
41d Input section,
41e Input section,
41f Input section,
42 Junction point,
43 Output section,
431 Output section,
432 Output section,
44 One-dimensional confluent fine wire structure,
45a Cellular majority logic device,
45b Cellular majority logic device,
45c Cellular majority logic device,
46 Final junction point.

**Claims**

1. A majority logic device, comprising:

a nonmagnetic semiconductor layer comprising a material which, upon irradiation of light having at least two mutually different polarization states, generates electron spin waves having different phases depending on the polarization states,
wherein the nonmagnetic semiconductor layer comprises three or more input sections for inputting optical signals and at least one output section for outputting the result of interference of the electron spin waves and
wherein the deviation of the length of the projection of the distance between adjacent input sections in the oscillating direction of the electron spin wave from an integer multiple of the wavelength of the electron spin wave is within 25% of the wavelength.

2. The majority logic device according to claim **1,** wherein the length of the projection of the distance between adjacent input sections in the oscillating direction of the electron spin wave is an integer multiple of the wavelength of the electron spin wave.

3. The majority logic device according to claim 1 or **2,** further comprising a waveguide layer stacked directly or through another layer on the nonmagnetic semiconductor layer,

wherein the waveguide layer comprises waveguides individually connected to each of the three or more input sections directly or via other layers and
wherein the majority logic device has a mirror section for guiding light through the waveguide to the respective input section at the location where the waveguide is connected to each of the three or more input sections directly or individually through other layers.

4. The majority logic device according to claim **3,** wherein the waveguides are arranged in a direction that is substantially orthogonal to the oscillating direction of the electron spin wave.

5. The majority logic device according to claim 1 or 2, wherein the output section is located at an equal distance from each of the three or more input sections.

6. The majority logic device according to claim 1 or 2,

wherein the electron spin wave is an inverse Persistent Spin Helix generated in a two-dimensional electron gas and
wherein the three or more input sections are arranged in directions in plane of the nonmagnetic semiconductor layer.

7. The majority logic device according to claim 6, wherein the deviation between the absolute value of $\alpha$ and the absolute value of $\beta$ is within 15% of the average of the absolute values where the Rashba spin-orbit interaction coefficient is $\alpha$ and the Dresselhaus spin-orbit interaction coefficient is $\beta$.

8. The majority logic device according to claim 6, wherein the three or more input sections are located at each vertex of a polygon.

9. The majority logic device according to claim 8,

   wherein the three or more input sections are located at each vertex of an equilateral triangle and
   wherein the output section is located at the center of gravity of the equilateral triangle.

10. The majority logic device according to claim 1 or 2,

    wherein the electron spin wave is an electron spin wave transformed into a helical spin mode by confinement of a two-dimensional electron gas into a one-dimensional fine wire structure and
    wherein the three or more input sections are arranged in a one-dimensional direction on the nonmagnetic semiconductor layer.

11. A photoelectric conversion device, comprising:

    the majority logic device according to claim 1 or 2 and
    a magnetoresistive device for converting the spin polarization of the output section into an electrical signal.

12. An optical communication logic device, comprising:

    the majority logic device according to claim 1 or 2 and
    an optical output element.

13. An optical communication logic device, comprising:

    the majority logic device according to claim 1 or 2 and
    a wavelength multiplexed optical input element.

14. A method of controlling a majority logic device,

    wherein the majority logic device comprises a nonmagnetic semiconductor layer comprising a material which, upon irradiation of light having at least two mutually different polarization states, generates electron spin waves having different phases depending on the polarization states,
    wherein the nonmagnetic semiconductor layer comprises three or more input sections for inputting optical signals and at least one output section for outputting the result of interference of the electron spin waves,
    wherein the deviation of the length of the projection of the distance between adjacent input sections in the oscillating direction of the electron spin wave from an integer multiple of the wavelength of the electron spin wave is within 25% of the wavelength and

    wherein the optical signals are optical signals modulated with right-handed circularly polarized light and left-handed circularly polarized light.

15. The method of controlling a majority logic device according to claim 14,

    wherein the three or more input sections comprise a first input section and a second input section and
    wherein when the distance between the first input section and the output section is longer than the distance between the second input section and the output section, the intensity of the optical signal input to the first input section is compensated to be greater than the intensity of the optical signal input to the second input section.

16. The method of controlling a majority logic device according to claim 14,
    wherein at least one of the three or more input sections is input with an optical signal that is always either right-handed or left-handed circularly polarized.

17. A majority logic device, comprising:

    a two-dimensional wire structure in which three or more odd one-dimensional fine wire structures for signal input meet at a single junction point,
    wherein each of the one-dimensional fine wire structures for signal input has a nonmagnetic semiconductor layer comprising a material which, upon irradiation of light having at least two mutually different polarization states, generates electron spin waves having different phases depending on the polarization states,
    wherein each of the one-dimensional fine wire structures for signal input has an input section for inputting optical signals before the junction point,
    wherein the junction point comprises an output section which outputs the result of interference of the electron spin waves at the junction point and
    wherein the deviation of the length of the projection of the distance between the junction point and the respective input sections of the one-dimensional fine wire structure for signal input in the oscillating direction of the electron spin wave from an integer multiple of the wavelength of the electron spin wave is within 25% of the wavelength.

18. The majority logic device according to claim 17, wherein the electron spin wave is an inverse Persistent Spin Helix generated in a two-dimensional electron gas.

19. The majority logic device according to claim 18, wherein the deviation between the absolute value of $\alpha$ and the absolute value of $\beta$ is within 15% of the average of the absolute values where the Rashba spin-orbit interaction coefficient is $\alpha$ and the Dresselhaus spin-orbit interaction coefficient is $\beta$.

20. A majority logic device, comprising:

a two-dimensional wire structure in which three or more odd one-dimensional fine wire structures for signal input meet at a single junction point,
wherein each of the one-dimensional fine wire structures for signal input has a nonmagnetic semiconductor layer comprising a material which, upon irradiation of light having at least two mutually different polarization states, generates electron spin waves having different phases depending on the polarization states,
wherein each of the one-dimensional fine wire structures for signal input has an input section for inputting optical signals before the junction point,
wherein the junction point comprises an output section which outputs the result of interference of the electron spin waves at the junction point and
wherein the deviation of the distance between the junction point and the respective input sections of the one-dimensional fine wire structure for signal input from an integer multiple of the wavelength of the electron spin wave is within 25% of the wavelength.

21. The majority logic device according to claim 20, only the Rashba spin-orbit interaction is active as the spin-orbit interaction with respect to the electron spin wave.

22. The majority logic device according to any one of claims 17 to 21,

further comprising a one-dimensional confluent fine wire structure extending from the junction point,
wherein, instead of the junction point, the one-dimensional confluent fine wire structure comprises an output section.

23. A majority logic device, comprising:

a plurality of cellular majority logic devices each comprising a majority logic device according to claim 22,

wherein one-dimensional confluent fine wire structures of the plurality of cellular majority logic devices meet at a single final junction point and wherein an output section is provided which outputs the results of interference of the electron spin waves at the final junction point.

# FIG. 1

# FIG. 2

RIGHT-HANDED OR LEFT-HANDED CIRCULARLY POLARIZED LIGHT

READOUT OF RESULT

20a 20b 20c 30 10

ELECTRON SPIN WAVE

ELECTRON SPIN WAVE AFTER INTERFERENCE

EP 4 579 378 A1

# FIG. 3

t=0.000ns

20 c

10

1

30

$(20a, 20b, 20c) = (0, 0, 0)$

20a

20 b

y

x

t = 0.700 ns

-50

y (μm)

0

50

-50          0          50

x (μm)

# FIG. 4

t=0.000ns

$(20a,20b,20c)=(0,0,1)$

t = 0.700 ns

# FIG. 5

# FIG. 6

FIG. 7

FIG. 8

# FIG. 9

EP 4 579 378 A1

FIG. 10

# FIG. 11

EP 4 579 378 A1

# FIG. 12

t=0.000ns 13

20m 20o

33

$(20m, 20n, 20o) = (0, 0, 1)$

20n

Δx

λ  λ

y

x

EP 4 579 378 A1

FIG. 13

EP 4 579 378 A1

$(x,y) = (0,0)$

# FIG. 14

t=0.000ns

Δx=0

y

x

t = 1.000 ns

LOGICAL VALUE = 1

y (μm)

x (μm)

# FIG. 15

t=0.000ns

Δx=0.2 λ

t = 1.000 ns

LOGICAL VALUE = 1

x (μm)

FIG. 16

t=0.000ns

t = 1.000 ns

LOGICAL VALUE = 0

FIG. 17

$(x,y) = (0,0)$

FIG. 18

EP 4 579 378 A1

FIG. 19

EP 4 579 378 A1

# FIG. 20

FIG. 21

FIG. 22

# FIG. 23

FIG. 24

EP 4 579 378 A1

## INTERNATIONAL SEARCH REPORT

| International application No. |
| :--- |
| **PCT/JP2023/030163** |

**A.    CLASSIFICATION OF SUBJECT MATTER**

*G06E 1/00*(2006.01)i; *H03K 19/23*(2006.01)i; *G06N 10/00*(2022.01)i; *H01L 29/66*(2006.01)i; *H01L 29/82*(2006.01)i; *H10N 50/10*(2023.01)i

FI:    G06N10/00; G06E1/00; H01L29/66; H01L29/82; H03K19/23; H10N50/10

According to International Patent Classification (IPC) or to both national classification and IPC

**B.    FIELDS SEARCHED**

Minimum documentation searched (classification system followed by classification symbols)

G06E1/00; H03K19/23; G06N10/00; H01L29/66; H01L29/82; H10N50/10

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C.    DOCUMENTS CONSIDERED TO BE RELEVANT**

| Category* | Citation of document, with indication, where appropriate, of the relevant passages | Relevant to claim No. |
| :---: | :--- | :---: |
| A | JP 2015-518267 A (INTERNATIONAL BUSINESS MACHINES CORPORATION) 25 June 2015 (2015-06-25)<br>    entire text | 1-23 |

☐ Further documents are listed in the continuation of Box C.          ☑ See patent family annex.

| | | | |
| :--- | :--- | :--- | :--- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| :--- | :--- |
| **19 September 2023** | **03 October 2023** |

| Name and mailing address of the ISA/JP | Authorized officer |
| :--- | :--- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
Information on patent family members

International application No.

**PCT/JP2023/030163**

| Patent document cited in search report | Publication date (day/month/year) | Patent family member(s) | Publication date (day/month/year) |
|---|---|---|---|
| JP 2015-518267 A | 25 June 2015 | US 2013/0314985 A1 <br> entire text <br> WO 2013/175326 A1 <br> entire text <br> CA 2871822 A <br> entire text <br> CN 104335324 A <br> entire text <br> KR 10-2015-0034673 A <br> entire text <br> GB 2502312 A <br> entire text | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2015518267 A

**Non-patent literature cited in the description**

- **TALMELLI et al.** Reconfigurable submicrometer spin-wave majority gate with electrical transducers. *Science Advances*, 18 December 2020, vol. 6 (51), eabb4042
- **YOSHIZUMI, A. SASAKI** ; **M. KOHDA** ; **J. NITTA**. Gate-controlled switching between persistent and inverse persistent spin helix states. *APPLIED PHYSICS LETTERS*, 2016, vol. 108, 132402
- **M. P. WALSER** ; **C. REICHL** ; **W. WEGSCHEIDER** ; **G. SALIS**. Direct mapping of the formation of a persistent spin helix. *Nature Phys. advance online publication*, 12 August 2012